# EUROPEAN PATENT APPLICATION

(11) **EP 2 698 834 A1**
(43) Date of publication of application: **19.02.2014**
(21) Application number: 12180839.8
(22) Date of filing: 17.08.2012
(51) Int. Cl.: H01L 51/00

(54) **Fullerene derivatives with reduced electron affinity and a photovoltaic cell using the same**

(71) Applicant: LANXESS Deutschland GmbH, 50569 Köln (DE); Institute of Problems of Chemical Physics of the Russian Academy of Sciences, Chernogolovka, Moscow Region 142432 (RU)
(72) Inventor: Mumyatov, Alexander V., Moscow region, 142432 (RU); Susarova, Diana K., Moscow region, 142432 (RU); Mukhacheva, Olga A., Moscow region, 142432 (RU); Troshin, Pavel A., Dr., Moscow region, 142432 (RU); Razumov, Vladimir F., Prof., Moscow region, 142432 (RU)
(74) Representative: Wichmann, Birgid

(57) **Abstract**

The present invention relates to the use of certain fullerene derivatives in optoelectronic devices, preferably in photovoltaic cells, especially preferably in organic photovoltaic cells to improve the open circuit voltage and energy conversion efficiency of solar cells.

## Description

The present invention relates to the use of certain substituted fullerenes in photovoltaic cells, preferably in organic photovoltaic cells, especially preferred in organic bulk heterojunction solar cells and photodetectors to improve the photogenerated voltage and energy conversion efficiency of the devices.

Photovoltaic devices allow the most simple and efficient conversion of the solar energy to electricity. The first generation of solar cells based on crystalline silicon is known since the middle of the last century. However, wide scale distribution of such devices has been long time limited by their extremely high cost. The typical installation cost of the solar cells based on crystalline silicon technologies stays in the range 2-3 USD per every watt of energy generated at maximal (peak) solar irradiance, denoted as watt-peak, Wₚ. Organic solar cells are expected to be able for producing electricity at costs around 20 cents per Wₚ. This level might be approached by implementation of the devices yielding reasonably high power conversion efficiencies of 8-16% at very low module costs (40-60 USD/m²). Further improvements of organic solar cells in terms of performance, life-time, module design and production technologies might lead to a breakthrough in the renewable energy technology. At the end, the energy generated by solar light conversion should become cheaper than the energy that we currently produce by combustion of fossil fuels.

There are also many additional advantages of the organic thin film solar cells that can be illustrated as follows.
- Mechanical flexibility allows one to adapt them to any curved surfaces;
- Light weight nature of thin film solar cells makes them ideal suiting for portable electronics applications;
- Integration into cloths (power-suite) and military canopies has been already demonstrated;
- High sensitivity at low light intensities allows for indoor applications to collect scattered light, preferably for their use as decorative energy-generating wall-paper

Different examples of organic solar cells have entered the phase of commercialization recently. However, the market potential of organic solar cells is limited by their relatively low power conversion efficiency and short life times. Therefore, substantial improvements of the photoactive material combinations and the device architectures are required.

Use of fullerene derivatives with reduced electron affinity is one of the most promising ways for improving the performance of organic photovoltaic devices;

The use of fullerene derivatives in photovoltaic cells was already described in DE 19 515 305 A1.

US 6 380 027 B2 discloses the use of fullerene derivatives in solar cells. The use of fullerene derivatives in the active layer-N-type material of photovoltaic cells is described in US 2010/0043876 A1.

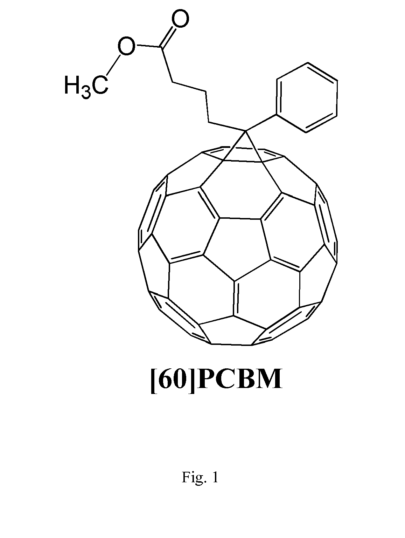

Science 1995, 270, 1789-1791 describes the use of [6,6]-phenyl-C₆₁-butyric acid methylester ([60]-PCBM, hereinafter also referred to as PCBM, the formula is shown in Fig.1) to enhance the high power-conversion efficiencies in polymeric solar cells.

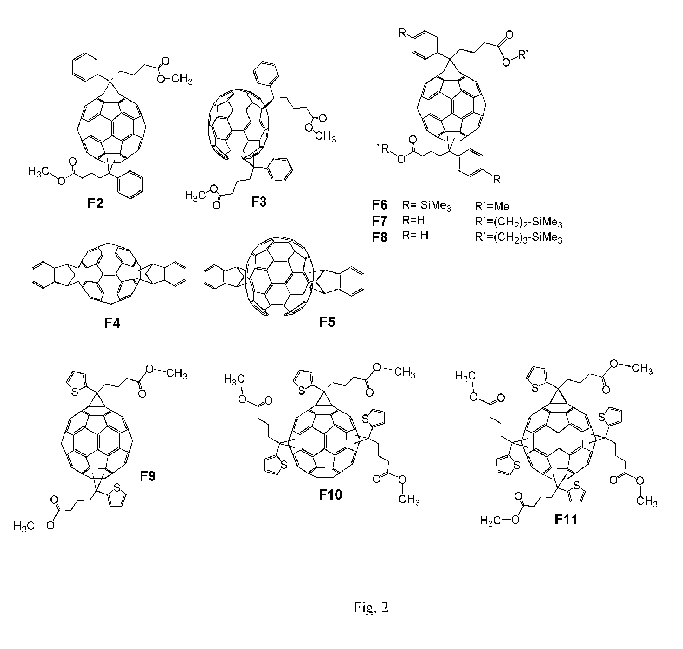

The use of Bis-[70]-PCBM and Bis-[60]-PCBM (see Fig.2) in photovoltaic cells is described in US 2010/0224252 A1. Adv. Mater., 2008, 20, 2116 describes the use of bis-PCBM adducts with reduced electron affinity for enhancing the electrical performance of organic solar cells;

WO 2009/086210 A2, Am. Chem. Soc. 2010, 132, 17381-17383; J. Mater. Chem., 2010, 20, 47; J. Mater. Chem., 2010, 20, 475; Adv. Mater, 2010, 22, 2283; Adv. Mater. 2010, 22, 4355; Mol. Cryst. Liq. Cryst. 2010, 519, 266, and J. Mater. Chem., 2011, 21, 17345 they all disclose the use of other types of fullerene bis-adducts as acceptors for the construction of improved poly(3-hexylthiophene) (P3HT)-based solar cells (see Fig.2, showing molecular structures of some fullerene bis-adducts applied for construction of improved organic solar cells according to the prior art).

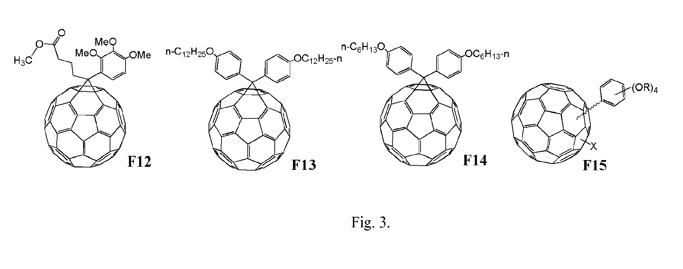

Adv. Funct. Mater., 2005, 15, 1979-1987; Org. Lett., 2007, 9, 551-554, and J. Mater. Chem., 2010, 21, 1382 first described the use of methoxyphenyl or alkoxyphenyl substituents to decrease the electron affinity of the fullerene derivatives and increase the voltage of organic solar cells (Fig. 3 shows fullerene derivates with alkoxyphenyl groups applied as electron acceptor materials in organic solar cells).

W02011/160021 A2 demonstrates the use of fullerene derivatives comprising tetraalkoxyphenyl substituents to increase the voltage and energy conversion efficiency of organic solar cells (Fig. 3).

JP2012020949 A2 discloses the use of fullerene derivatives with reduced electron affinity, particularly those comprising the substituted phenyl groups of the following structures: 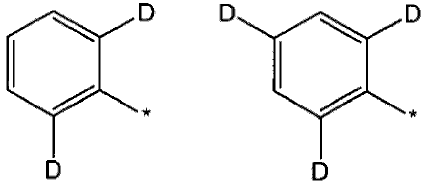 where D = OR, SR, NR₂ and R = C₁-C₃₀ alkyl group.

A number of other fullerene derivatives with reduced electron affinity are known from Photovoltaics (2010), 89; J. Mater. Chem. (2010), 20(29), 6170; Physical Chemistry Chemical Physics (2010), 12(18), 4656; Physica Status Solidi RRL: Rapid Research Letters (2008), 2(6), 260; Am. Chem. Soc., 2001, 123, 6715; Thin Solid Films 2004, 451―452, 43; J. Org. Chem. 2006, 71, 2995; J. Am. Chem. Soc. 2008, 130, 6447; J. Phys. Chem. C, 2009, 113, 21970; J. Fluor. Chem. 2009, 130, 361 and US 20070202413 (Fig. 3).

Use of fullerene derivatives having alkoxyphenyl groups for increasing the voltage in organic solar cells are already known from the prior art as well. However, it was not possible to achieve significant increase in the energy conversion efficiency of organic solar cells by using such fullerene derivatives having alkoxyphenyl groups. Typically, the increase in the open circuit voltage was counterbalanced by decreased short circuit current and fill factor. Such kind of behavior was observed for many compounds described in previous reports. For instance, Adv. Funct. Mater., 2005, 15, 1979-1987 and Org. Lett., 2007, 9, 551-554 documented no particular improvement in the solar cell efficiency related to the use of fullerene derivatives having alkoxyphenyl substituents. W02011/160021 A2 and JP2012020949 A2 reported very low efficient solar cells with energy conversion efficiencies in the range of 1.0-3.2%. Use of fullerene derivatives having methoxyphenyl substituents resulted in a small (50-60 mV) increase in the open circuit voltage and rather minor (0.4% in JP2012020949 A2 and 0-0.7% in WO2011/16002 A2) increase in the energy conversion efficiency of organic solar cells.

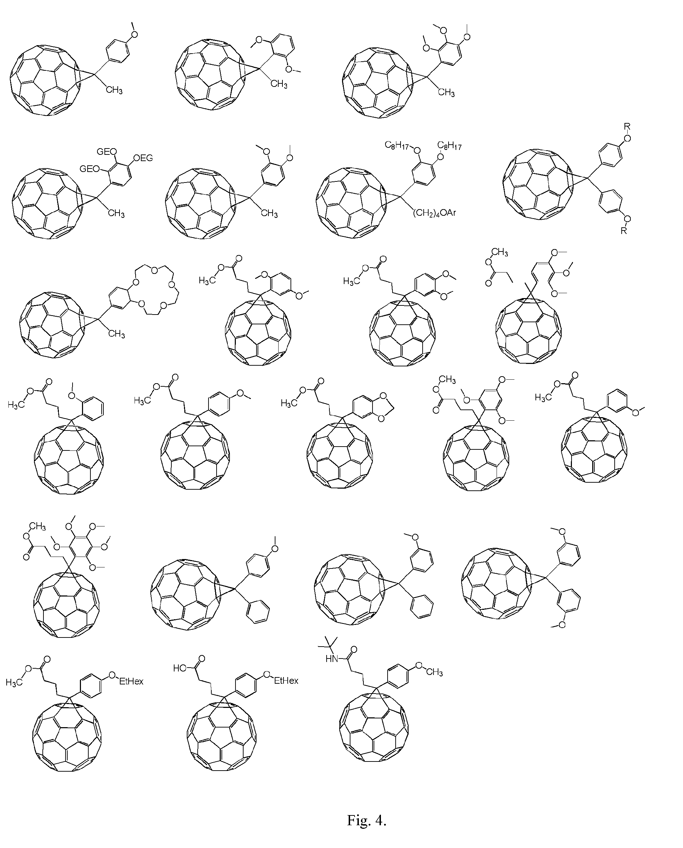

Poor solar cell performance of the alkoxyphenyl substituted fullerene derivatives reported by now is related to their unbalanced electronic and physical properties. It is not clear at the moment what is an optimal number of phenyl substituents D (see the formulas above) in one phenyl group in JP2012020949 A2 and what are their optimal positions in the phenyl ring introduced in the structure of the fullerene derivative. The lengths of the alkyl groups were also insufficiently considered yet. Some alkoxyphenyl-substituted cyclopropane-type fullerene derivates according to the prior art are described in Fig. 4.

With respect to the above described disadvantages of the fullerene derivatives with reduced electron affinity achieved via alkoxyphenyl substitution, it therefore was an object of the present invention to provide appropriately designed fullerene derivatives characterized by the following properties:
1) provide considerable improvement in the open circuit voltage of organic solar cells compared to the reference systems where PCBM is used as electron acceptor;
2) possess good compatibility with different electron donor components, e.g. conjugated polymers and oligomers, resulting in the optimal composite morphology;
3) consequently provide considerable improvement in the energy conversion efficiency of organic solar cells compared to the reference systems where PCBM is used as electron acceptor;
4) have appropriate physical properties, e.g. sufficient solubility in organic solvent required for solution processing, sufficient thermal stability and photostability to enable long lifetimes of organic solar cells and etc.

The object is achieved by novel compounds of the formula (1) 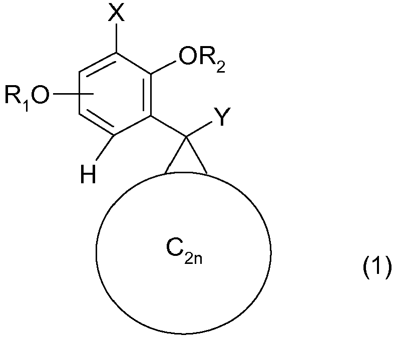 wherein
C₂ₙ is a carbon cage of C₆₀ or C₇₀ fullerene bearing the pendant cyclopropane-type addend,
X represents a substitutent selected from the group of a hydrogen atom, a halogen atom, an optionally substituted C₂-C₂₀ alkyl group, a C₂-C₂₀ fluorinated alkyl group, a C₂-C₂₀ alkyl- ether group, a C₂-C₂₀ alkoxy group, a C₂-C₂₀ fluoroalkoxy group, a C₂-C₂₀ alkylthio group, a C₂-C₂₀ fluoroalkylthio group, a C₅-C₂₀ alkylenearyl group or a C₅-C₂₀ alkyleneheteroaryl group,
Y represents a substitutent selected from the group of a hydrogen atom, an optionally substituted C₁-C₂₀ alkyl chain, a C₁-C₂₀ fluorinated alkyl group, a C₁-C₂₀ alkylether group, a C₁-C₂₀ fluorinated alkylether group, a C₅-C₂₀ alkylenearyl group or a C₅-C₂₀ alkyleneheteroaryl group, an unsubstituted phenyl group, a phenyl group substituted at positions 2 and 4, a phenyl group substituted at positions 2 and 5, a phenyl group substituted at positions 2,3 and 4, a 2-thienyl group substituted at position 5, a (CH₂)₁-₂₀COOR group, wherein R represents an optionally substituted C₁-C₂₀ alkyl group, a C₁-C₂₀ fluorinated alkyl group, a C₁-C₂₀ alkylether group, or a C₁-C₂₀ fluorinated alkylether group, and
R₁ and R₂ are the same or independent from each other and represent an optionally substituted C₃-C₂₀ alkyl group, a C₃-C₂₀ fluorinated alkyl group, a C₂-C₂₀ alkylether group, a C₂-C₂₀ fluorinated alkylether group, a C₅-C₂₀ alkylenearyl group or a alkyleneheteroaryl group or a (CH₂)₁-₂₀COOR group, wherein R represents an otionally substituted C₁-C₂₀ alkyl group, a C₁-C₂₀ fluorinated alkyl group, a C₂-C₂₀ alkylether group, or a fluorinated C₂-C₂₀ alkylether group.

In a preferred embodiment the present invention relates to a compound of formula (1) wherein X and Y have the above meanings with the proviso when X≠H, R₁ and R₂ in formula (1) are the same or independent from each other and represent an optionally substituted C₁-C₂₀ alkyl group, a C₁-C₂₀ fluorinated alkyl group, a C₁-C₂₀ fluorinated alkylether group, a C₁-C₂₀ alkylenearyl group or an alkyleneheteroaryl group or a (CH₂)₁-₂₀COOR group, wherein R represents an optionally substituted C₁-C₂₀ alkyl group, a C₁-C₂₀ fluorinated alkyl group, a C₁-C₂₀ alkylether group, or a C₁-C₂₀ fluorinated alkylether group.

In another preferred embodiment the present invention is directed to a compound of general formula (1) wherein X and Y have the above given meanings with the proviso when X=H, R₁ and R₂ in formula (1) are the same or independent from each other and represent an optionally substituted C₃-C₂₀ alkyl group, a C₃-C₂₀ fluorinated alkyl group, a C₂-C₂₀ alkylether group, a C₂-C₂₀ fluorinated alkylether group, a C₅-C₂₀ alkylenearyl group or a alkyleneheteroaryl group or a (CH₂)₁-₂₀COOR group, wherein R represents an otionally substituted C₁-C₂₀ alkyl group, a C₁-C₂₀ fluorinated alkyl group, a C₂-C₂₀ alkylether group, or a fluorinated C₂-C₂₀ alkylether group.

For clarification, it should be noted that the scope of the invention encompasses all of the definitions and parameters listed in general terms or in preferred ranges in the present specification, in any desired combination. Additionally "[60] " represents a C₆₀ fullerene and "[70]" represents a C₇₀ fullerene and C₂ₙ represents either a C₆₀ fullerene or a C₇₀ fullerene system.

In a preferred embodiment of the present invention Y in formula (1) represents a C₁-C₂₀ alkyl group;

In a preferred embodiment of the present invention Y in formula (1) represents an optionally substituted phenyl or 2-thienyl group;

In a very preferred embodiment of the present invention Y in formula (1) represents a C₁-C₂₀ alkyl group or a substitutent selected from the group of an unsubstituted phenyl group, a phenyl group substituted at positions 2 and 4, a phenyl group substituted at positions 2 and 5, a phenyl group substituted at positions 2,3 and 4 or a 2-thienyl group unsubstituted or substituted at positions 4 and/or 5.

In another very preferred embodiment of the present invention Y represents a 2-thienyl group unsubstituted or substituted at positions 4 and/or 5;

In a very preferred embodiment of the present invention Y in formula (1) represents a 2,4-(RO)₂C₆H₃-group or a 2,5-(RO)₂C₆H₃-group, wherein the radicals R represent independent from each other a C₃-C₂₀ alkyl group, a C₃-C₂₀ fluorinated alkyl group, a C₂-C₂₀ alkylether group, a C₂-C₂₀ fluorinated alkylether group, or a (CH₂)₁-₂₀COOR group, wherein R represents an optionally substituted C₁-C₂₀ alkyl group, a C₁-C₂₀ fluorinated alkyl group, a C₂-C₂₀ alkylether group, or a fluorinated C₂-C₂₀ alkylether group.

In another very preferred embodiment of the present invention Y represents a group of formula (2), 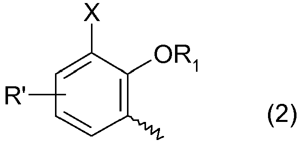 wherein radical R' is a C₂-C₂₀ alkyl group, a C₂-C₂₀ fluorinated alkyl group, a C₂-C₂₀ alkyl ether group, a C₂-C₂₀ alkoxy group, a C₂-C₂₀ fluoroalkoxy group, a C₂-C₂₀ alkylthio group, a C₂-C₂₀ fluoroalkylthio group, or a (CH₂)₁-₂₀COOR group, wherein R represents an optionally substituted C₁-C₂₀ alkyl group, a C₁-C₂₀ fluorinated alkyl group, a C₂-C₂₀ alkylether group, or a fluorinated C₂-C₂₀ alkylether group, while X and R₁ have the above given meanings.

In another very preferred embodiment of the present invention Y represents a C₁-C₈ branched or unbranched alkyl group.

In a very especially preferred embodiment of the present invention Y represents a methyl group.

In a preferred embodiment of the present invention X represents an optionally substituted C₂-C₂₀ alkyl group, a C₂-C₂₀ fluorinated alkyl group, a C₂-C₂₀ alkoxy group, or a C₂-C₂₀ fluoroalkoxy group.

In a very preferred embodiment of the present invention X represents an optionally substituted C₂-C₂₀ alkoxy group.

In another very preferred embodiment of the present invention X represents a hydrogen atom.

In a preferred embodiment of the present invention R₁O and R₂O are attached at positions 2 and 4 of the phenyl ring in formula (1).

In another preferred embodiment of the present invention R₁O and R₂O are attached at positions 2 and 5 of the phenyl ring in formula (1).

In a preferred embodiment of the present invention R₁ and R₂ are the same or independent from each other and represent an optionally substituted C₁-C₂₀ alkyl group or a C₁-C₂₀ fluorinated alkyl group.

In a very preferred embodiment of the present invention R₁ and R₂ represent the same C₁-C₈ alkyl group.

In a preferred embodiment of the present invention the fullerene derivatives according to the present invention are used in a mixture of at least any two compounds of general formula (1) taken in any appropriate ratio.

In a very preferred embodiment of the present invention the fullerene derivatives according to the present invention are used in a mixture of at least any two compounds of general formula (1) taken in any appropriate ratio in combination with 0.0001 to 99.9999% of a third component which might be represented by some functionalized higher fullerene C>70, some solvent, some processing additive but any other functional component improving or not affecting the performance of the fullerene derivatives in the claimed optoelectronic devices, preferably in organic photovoltaic cells.

Without limiting the present invention fullerene derivatives according to the general formula (1), are preferably those having two alkoxy substituents at positions 2 and 4 of the phenyl ring as shown in the formula (1a), or two alkoxy substituents at positions 2 and 5 of the phenyl ring as shown in the formula (1b), or three alkoxy substituents at positions 2, 3 and 4 of the phenyl ring as shown in the formula (1c) wherein R₃ has the same definition as given above for R₁ and R₂ and C₂ₙ represents either a C₆₀ fullerene or a C₇₀ fullerene system, preferably a C₆₀ fullerene system.

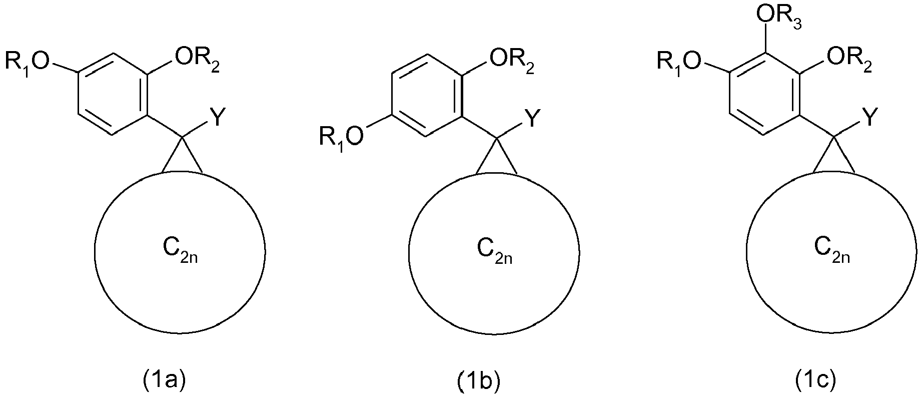

Surprisingly the fullerene derivatives according to the present invention have unexpectedly lower electron affinity compared to the reference material PCBM. The first electrochemical reduction potential of the fullerene derivative determined as described in J. Org. Chem. 1995,60, 532 can be considered as a measure of the electronic affinity. [60]-PCBM according to Fig. 1 has a reduction potential of -1.135 V vs Fc/Fc⁺. Fullerene derivatives with lower electron affinity should show more negative first reduction potentials (e.g. -1.140 V).

Without limiting the present invention it was found, that the fullerene derivatives according to the general formula **(1),** particularly the ones having two C₄-C₂₀ alkyloxy substituents in the phenyl ring as shown in formulas **(1a)** and **(1b),** or the ones possessing a single C₅-C₂₀ alkyloxy substituent in combination with two C₁-C₂ alkyloxy substituents as shown in formula (1d), demonstrate unexpectedly significantly improved compatibility with a range of conjugated polymers. Examples given in the literature and in the embodiments of the present invention prove that alternative arrangements of two alkoxy groups (e.g. positions 3,4 or 2,6 of the phenyl ring) and three alkoxy groups (e.g. positions 3,4,5 or 2,4,6 of the phenyl ring) provide inferior compatibility of the fullerene derivatives with conjugated polymers and, consequently, inferior photovoltaic properties.

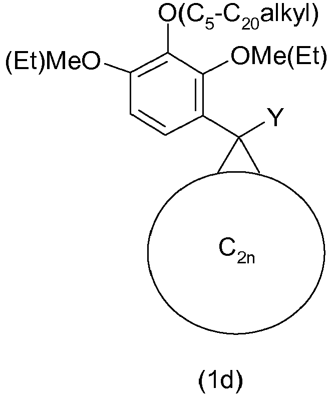

The fullerene derivatives disclosed in the present invention can be synthesized using methods known in the prior art. As an example, a fullerene derivative of the formula (1e) can be prepared using the following scheme:

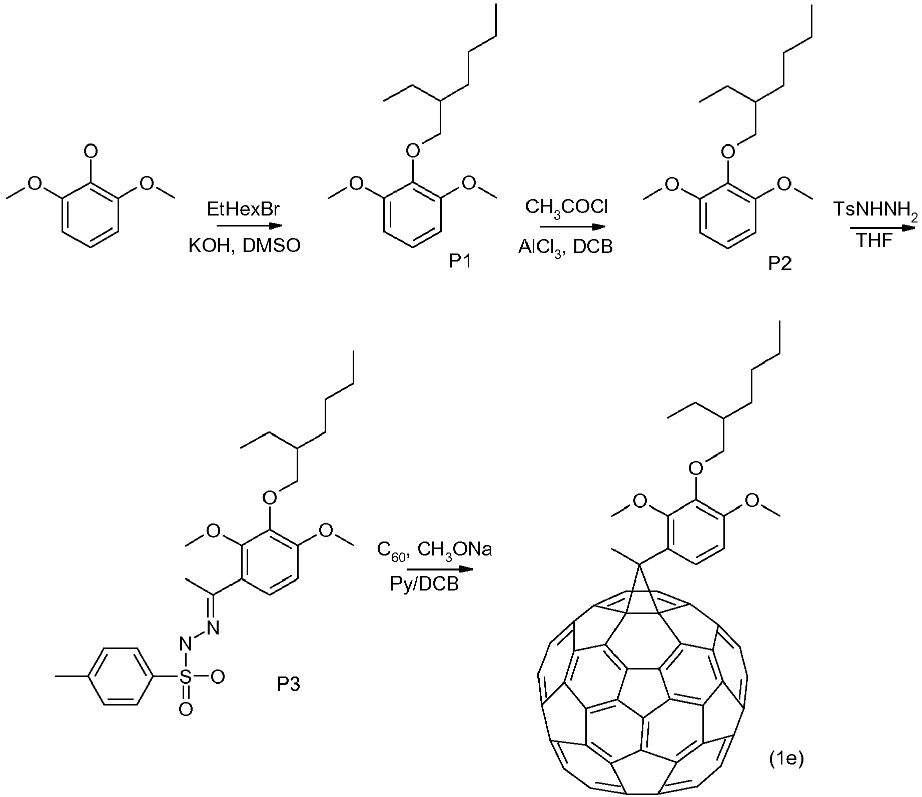

A commercially available 2,6-dimethoxyphenol was alkylated with 2-ethylhexyl bromide to obtain compound P1, which further reacted with acetyl chloride in the presence of AlCl₃ to form acetophenone P2. Treatment of P2 with p-tosylhydrazide produced P3. A reaction of P3 with NaOMe and C₆₀ in 1,2-dichlorobenzene/pyridine mixture produced compound (1e) after chromatographic separation on silica.

A very preferred object of the present invention are fullerene derivatives of formula (1f) 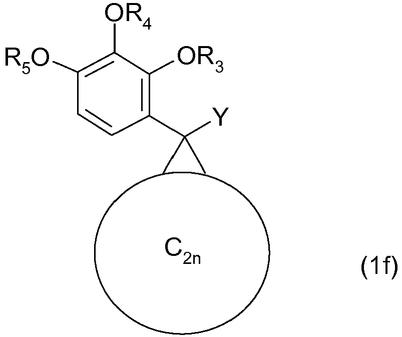 wherein Y represents methyl group, R₃ and R₅ are independent from each other and represent a branched or unbranched C₁-C₈ alkyl group, R₄ represents a branched or unbranched C₃-C₈ alkyl group and C₂ₙ represents either a C₆₀ fullerene or a C₇₀ fullerene system, preferably a C₆₀ fullerene system.

An especially preferred object of the present invention are fullerene derivatives of formula **(1f)** wherein Y = methyl, R₃ and R₅ = methyl, ethyl, i-propyl, n-propyl, i-butyl, n-butyl, t-butyl, n-pentyl or i-pentyl, preferably i-pentyl or methyl and R₄ = branched or unbranched C₅-C₈ alkyl group, preferably a branched C₅ or a branched C₈ group.

Particularly preferred are the fullerene compounds according to the present invention according to Table 1

**Table 1**

| No. | Fullerene derivative |
|---|---|
| (1g) | 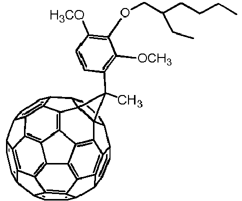 |
| (1h) | 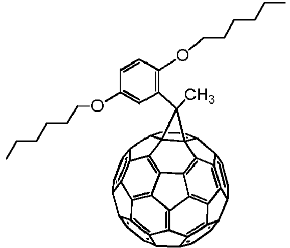 |
| (1i) | 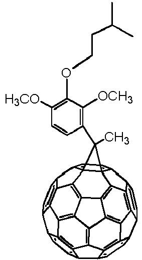 |
| (1j) | 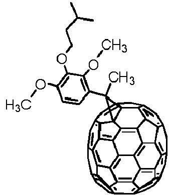 |
| (1k) | 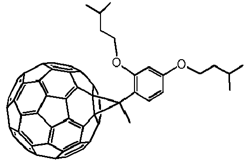 |
| (1l) | 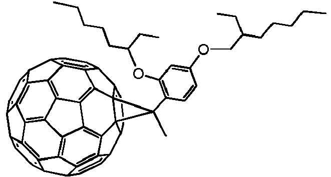 |
| (1m) | 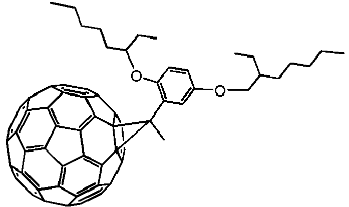 |
| (1n) | 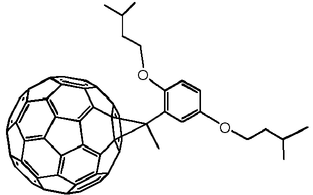 |
| (1o) | 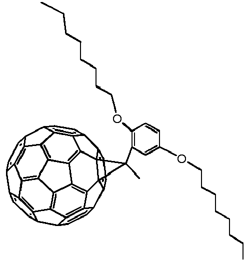 |
| (1p) | 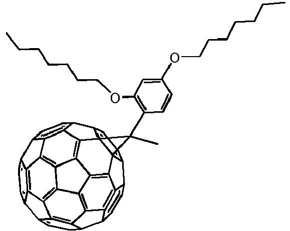 |
| (1q) | 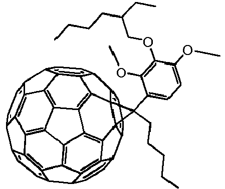 |
| (1r) | 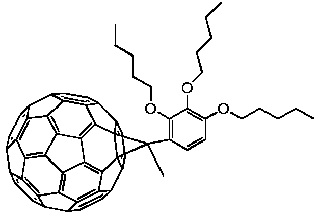 |
| (1s) | 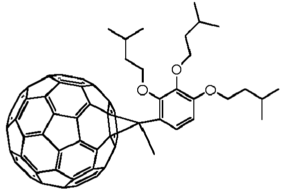 |
| (1t) | 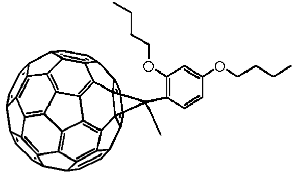 |
| (1u) | 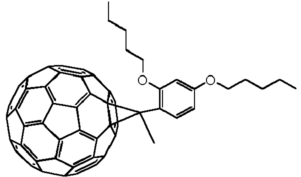 |
| (1v) | 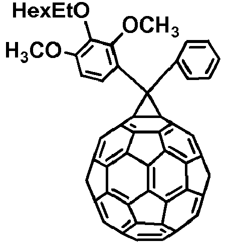 |
| (1w) | 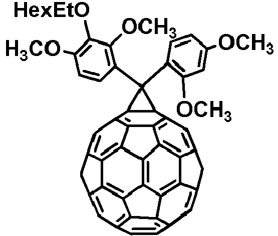 |
| (1x) | 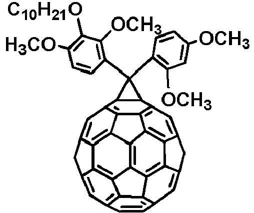 |

In the light of the foregoing, the present teachings provide certain polymeric compounds that can be used as organic semiconductor materials. Also provided are associated devices and related methods for the preparation and use of these compounds. The present compounds can exhibit properties such as optimized optical absorption, good charge transport characteristics and chemical stability in ambient conditions, low-temperature processability, large solubility in common solvents, and processing versatility (e.g. via various solution processes). As a result, optoelectronic devices, preferably solar cells, that incorporate one or more of the present compounds as a photoactive layer can exhibit high performance in ambient conditions, for example, demonstrating one or more of low band-gap, high fill factor, high open circuit voltage, and high power conversion efficiency, and preferably all of the these criteria. Similarly, other organic semiconductor-based devices such as organic light emitting transistors (OLETs) can be fabricated efficiently using the organic semiconductor materials described herein.

The present teachings also provide methods for preparing such compounds and semiconductor materials, as well as various compositions, composites, and devices that incorporate the compounds and semiconductor materials disclosed herein.

It should be understood that the drawings and Fig.1 to Fig.5 within this specification are for illustration purposes only. The drawings are not necessarily to scale, with emphasis generally being placed upon illustrating the principles of the present teachings. The drawings are not intended to limit the scope of the present teachings in any way.

Compounds of the present teachings can exhibit semiconductor behaviour such as optimized light absorption/charge separation in a photovoltaic device; charge transport/recombination/light emission in a light-emitting device; and/or high carrier mobility and/or good current modulation characteristics in a field-effect device. In addition, the present compounds can posses certain processing advantages such as solution-processability and/or good stability (e.g. air stability) in ambient conditions. The compounds of the present teachings can be used to prepare either p-type (donor or hole-transporting), n-type (acceptor or electron-transporting), or ambipolar semiconductor materials, which in turn can be used to fabricate various organic or hybrid optoelectronic articles, structures and devices, including organic photovoltaic devices and organic light-emitting transistors.

Throughout the application, where compositions are described as having, including, or comprising specific components, or where processes are described as having, including, or comprising specific process steps, it is contemplated that compositions of the present teachings also consist essentially of, or consist of, the recited components, and that the processes of the present teachings also consist of, the recited process steps.

In the application, where an element or component is said to be included in and/or selected from a list of recited elements or components, it should be understood that the element or component can be any one of the recited elements or components, or the element or component can be selected from a group consisting of two or more of the recited elements or components. Further, it should be understood that elements and/or features of a composition, an apparatus, or a method described herein can be combined in a variety of ways without departing from the spirit and scope of the present teachings, whether explicit or implicit herein.

The use of the terms "include", "includes", "including", "have", "has", or "having" should be generally understood as open-ended and non-limiting unless specifically stated otherwise.

The use of the singular herein includes the plural (and vice versa) unless specifically stated otherwise. In addition, where the use of the term "about" is before a quantitative value, the present teachings also include the specific quantitative value itself, unless specifically stated otherwise. As used herein, the term "about" refers to ± 10% variation from the nominal value unless otherwise indicated or inferred.

It should be understood that the order of steps or order for performing certain actions is immaterial so long as the present teachings remain operable. Moreover, two or more steps or actions may be conducted simultaneously.

As used herein, a "p-type semiconductor material" or a "donor" material refers to a semiconductor material, for example, an organic semiconductor material, having holes as the majority current or charge carriers. In some embodiments, when a p-type semiconductor material is deposited on a substrate, it can provide a hole mobility in excess of about 10⁻⁵ cm²/Vs. In the case of field-effect devices, a p-type semiconductor also can be exhibit a current on/off ratio of greater than about 10.

As used herein, an "n-type semiconductor material" or an "acceptor" material refers to a semiconductor material, for example, an organic semiconductor material, having electrons as the majority current or charge carriers. In some embodiments, when an n-type semiconductor material is deposited on a substrate, it can provide an electron mobility in excess of about 10⁻⁵ cm²/Vs. In the case of field-effect devices, an n-type semiconductor also can exhibit a current on/off ratio of greater than about 10.

As used herein, "mobility" refers to a measure of the velocity with which charge carriers, for example, holes (or units of positive charge) in the case of a p-type semiconductor material and electrons (or units of negative charge) in the case of an n-type semiconductor material, move through the material under the influence of an electric field. This parameter, which depends on the device architecture, can be measured using a field-effect device or space-charge limited current measurements.

As used herein, the power conversion efficiency (PCE) of a solar cell is the percentage of power converted from absorbed light to electrical energy. The PCE of a solar cell can be calculated by dividing the maximum power point (Pₘ) by the input light irradiance (E, in w/m2) under standard test conditions (STC) and the surface area of the solar cell (A_{c}, in m²). STC typically refers to a temperature of 25°C and an irradiance of 1000 w/m² with an air mass 1.5 (AM 1.5) spectrum.

As used herein, a component (such as a thin film layer) can be considered "photoactive" if it contains one or more compounds that can absorb photons to produce excitons for the generation of a photocurrent.

As used herein, "solution-processable" refers to compounds, preferably polymers, materials, or compositions that can be used in various solution-phase processes including spin-coating, printing, preferably inkjet printing, gravure printing, offset printing and the like, spray coating, electrospray coating, drop casting, dip coating, and blade coating.

As used herein, a "polymeric compound (or "polymer") refers to a molecule including a plurality of one or more repeating units connected by covalent chemical bonds. A polymeric compound can be represented by the general formula: 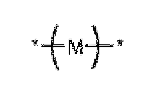 wherein M is the repeating unit or monomer. The polymeric compound can have only one type of repeating unit as well as two or more types of different repeating units. When a polymeric compound has only one type of repeating unit, it can be referred to as a homopolymer. When a polymeric compound has two or more types of different repeating units, the term "copolymer" or "copolymeric compound can be used instead. For example, a copolymeric compound can include repeating units 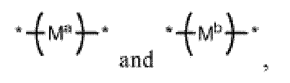 where M^{a} and M^{b} represent two different repeating units. Unless specified otherwise, the assembly of the repeating units in the copolymer can be head-to-tail, head-to-head, or tail-to-tail. In addition, unless specified otherwise, the copolymer can be a random copolymer, an alternating copolymer, or a block copolymer. For example, the general formula: 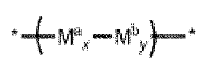 can be used to represent a copolymer of M^{a} and M^{b} having x mole fraction of M^{a} and y mole fraction of M^{b} in the copolymer, where the manner in which comonomers M^{a} and M^{b} is repeated can be alternating, random, regiorandom, regioregular, or in blocks. In addition to its composition, a polymeric compound can be further characterized by its degree of polymerization (n) and molar mass (e.g., number average molecular weight (Mₙ) and/or weight average molecular weight (M_{w}) depending on the measuring technique(s)).

As used herein, "halo" or "halogen" refers to fluoro, chloro, bromo, and iodo.

As used herein, "oxo" refers to a double-bonded oxygen (i.e., =O).

As used herein, "alkyl" refers to a straight-chain or branched saturated hydrocarbon group. Examples of alkyl groups include methyl (Me), ethyl (Et), propyl (e.g., n-propyl and iso-propyl), butyl (e.g., n-butyl, iso-butyl, sec-butyl, tert-butyl), pentyl groups (e.g., n-pentyl, iso-pentyl, neopentyl), hexyl groups, and the like. In various embodiments, an alkyl group can have 1 to 40 carbon atoms (i.e., C₁₋₄₀ alkyl group), for example, 1-20 carbon atoms (i.e., C₁₋₂₀ alkyl group). In some embodiments, an alkyl group can have 1 to 6 carbon atoms, and can be referred to as a "lower alkyl group." Examples of lower alkyl groups include methyl, ethyl, propyl (e.g., n-propyl and iso-propyl), and butyl groups (e.g., n-butyl, iso-butyl, secbutyl, tert-butyl). In some embodiments, alkyl groups can be substituted as described herein. An alkyl group is generally not substituted with another alkyl group, an alkenyl group, or an alkynyl group.

As used herein, "haloalkyl" refers to an alkyl group having one or more halogen substituents. At various embodiments, a haloalkyl group can have 1 to 40 carbon atoms (i.e., C₁₋₄₀haloalkyl group), for example, 1 to 20 carbon atoms (i.e., C₁₋₂₀ haloalkyl group). Preferred examples of haloalkyl groups include CF₃, C2F₅, CHF₂, CH₂F, CCl₃, CHCl₂, CH₂Cl, C₂Cl₅, and the like. Perhaloalkyl groups, i.e., alkyl groups where all of the hydrogen atoms are replaced with halogen atoms (e.g., CF₃ and C₂F₅), are included within the definition of "haloalkyl." For example, a C₁₋₄₀ haloalkyl group can have the formula -CₛH₂ₛ₊₁₋ₜX⁰ₜ, where X⁰, at each occurrence, is F, C1, Br or I, s is an integer in the range of 1 to 40, and t is an integer in the range of 1 to 81, provided that t is less than or equal to 2s+1. Haloalkyl groups that are not perhaloalkyl groups can be substituted as described herein.

As used herein, "alkoxy" refers to an -O-alkyl group. Examples of alkoxy groups include, but are not limited to, methoxy, ethoxy, propoxy (e.g., n-propoxy and isopropoxy), t-butoxy, pentoxyl, hexoxyl groups, and the like. The alkyl group in the -0-alkyl group can be substituted as described herein. As used herein, "alkylthio" refers to an -S-alkyl group. Examples of alkylthio groups include, but are not limited to, methylthio, ethylthio, propylthio (e.g., n-propylthio and isopropylthio), t-butylthio, pentylthio, hexylthio groups, and the like. The alkyl group in the -S-alkyl group can be substituted as described herein.

As used herein, "alkenyl" refers to a straight-chain or branched alkyl group having one or more carbon-carbon double bonds. Examples of alkenyl groups include ethenyl, propenyl, butenyl, pentenyl, hexenyl, butadienyl, pentadienyl, hexadienyl groups, and the like. The one or more carbon-carbon double bonds can be internal (such as in 2-butene) or terminal (such as in 1-butene). In various embodiments, an alkenyl group can have 2 to 40 carbon atoms (i.e., C₂₋₄₀ alkenyl group), for example, 2 to 20 carbon atoms (i.e., C₂₋₂₀ alkenyl group). In some embodiments, alkenyl groups can be substituted as described herein. An alkenyl group is generally not substituted with another alkenyl group, an alkyl group, or an alkynyl group.

As used herein, "alkynyl" refers to a straight-chain or branched alkyl group having one or more triple carbon-carbon bonds. Examples of alkynyl groups include ethynyl, propynyl, butynyl, pentynyl, hexynyl, and the like. The one or more triple carbon-carbon bonds can be internal (such as in 2-butyne) or terminal (such as in 1-butyne). In various embodiments, an alkynyl group can have 2 to 40 carbon atoms (i.e., C₂₋₄₀ alkynyl group), for example, 2 to 20 carbon atoms (i.e., C₂₋₂₀ alkynyl group). In some embodiments, alkynyl groups can be substituted as described herein. An alkynyl group is generally not substituted with another alkynyl group, an alkyl group, or an alkenyl group. As used herein, "cycloalkyl" refers to a non-aromatic carbocyclic group including cyclized alkyl, alkenyl, and alkynyl groups. In various embodiments, a cycloalkyl group can have 3 to 24 carbon atoms, for example, 3 to 20 carbon atoms (e.g., C₃₋₁₄ cycloalkyl group). A cycloalkyl group can be monocyclic (e.g., cyclohexyl) or polycyclic (e.g., containing fused, bridged, and/or spiro ring systems), where the carbon atoms are located inside or outside of the ring system. Any suitable ring position of the cycloalkyl group can be covalently linked to the defined chemical structure. Examples of cycloalkyl groups include cyclopropyl, cyclobutyl, cyclopentyl, cyclohexyl, cycloheptyl, cyclopentenyl, cyclohexenyl, cyclohexadienyl, cycloheptatrienyl, norbornyl, norpinyl, norcaryl, adamantyl, and spiro[4.5]decanyl groups, as well as their homologs, isomers, and the like. In some embodiments, cycloalkyl groups can be substituted as described herein.

As used herein, "heteroatom" refers to an atom of any element other than carbon or hydrogen and includes, for example, nitrogen, oxygen, silicon, sulfur, phosphorus, and selenium.

As used herein, "aryl" refers to an aromatic monocyclic hydrocarbon ring system or a polycyclic ring system in which two or more aromatic hydrocarbon rings are fused (i.e., having a bond in common with) together or at least one aromatic monocyclic hydrocarbon ring is fused to one or more cycloalkyl and/or cycloheteroalkyl rings. An aryl group can have 6 to 24 carbon atoms in its ring system (e.g., C₆₋₂₀ aryl group), which can include multiple fused rings. In some embodiments, a polycyclic aryl group can have 8 to 24 carbon atoms. Any suitable ring position of the aryl group can be covalently linked to the defined chemical structure. Examples of aryl groups having only aromatic carbocyclic ring(s) include phenyl, 1 -naphthyl (bicyclic), 2-naphthyl (bicyclic), anthracenyl (tricyclic), phenanthrenyl (tricyclic), pentacenyl (pentacyclic), and like groups. Examples of polycyclic ring systems in which at least one aromatic carbocyclic ring is fused to one or more cycloalkyl and/or cycloheteroalkyl rings include, among others, benzo derivatives of cyclopentane (i.e., an indanyl group, which is a 5,6-bicyclic cycloalkyl/aromatic ring system), cyclohexane (i.e., a tetrahydronaphthyl group, which is a 6,6-bicyclic cycloalkyl/aromatic ring system), imidazoline (i.e., a benzimidazolinyl group, which is a 5,6-bicyclic cycloheteroalkyl/aromatic ring system), and pyran (i.e., a chromenyl group, which is a 6,6-bicyclic cycloheteroalkyl/aromatic ring system). Other examples of aryl groups include benzodioxanyl, benzodioxolyl, chromanyl, indolinyl groups, and the like. In some embodiments, aryl groups can be substituted as described herein. In some embodiments, an aryl group can have one or more halogen substituents, and can be referred to as a "haloaryl" group. Perhaloaryl groups, i.e., aryl groups where all of the hydrogen atoms are replaced with halogen atoms (e.g., -C₆F₅), are included within the definition of "haloaryl." In certain embodiments, an aryl group is substituted with another aryl group and can be referred to as a biaryl group. Each of the aryl groups in the biaryl group can be substituted as disclosed herein.

As used herein, "heteroaryl" refers to an aromatic monocyclic ring system containing at least one ring heteroatom selected from oxygen (0), nitrogen (N), sulfur (S), silicon (Si), and selenium (Se) or a polycyclic ring system where at least one of the rings present in the ring system is aromatic and contains at least one ring heteroatom. Polycyclic heteroaryl groups include those having two or more heteroaryl rings fused together, as well as those having at least one monocyclic heteroaryl ring fused to one or more aromatic carbocyclic rings, non-aromatic carbocyclic rings, and/or non-aromatic cycloheteroalkyl rings. A heteroaryl group, as a whole, can have, for example, 5 to 24 ring atoms and contain 1-5 ring heteroatoms (i.e., 5-20 membered heteroaryl group). The heteroaryl group can be attached to the defined chemical structure at any heteroatom or carbon atom that results in a stable structure. Generally, heteroaryl rings do not contain 0-0, S-S, or S-0 bonds. However, one or more N or S atoms in a heteroaryl group can be oxidized (e.g., pyridine N-oxide, thiophene S-oxide, thiophene S,S-dioxide). Examples of heteroaryl groups include, for example, the 5- or 6-membered monocyclic and 5-6 bicyclic ring systems shown below: 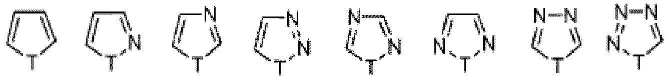 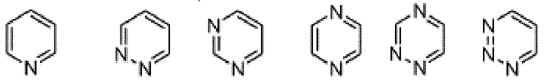 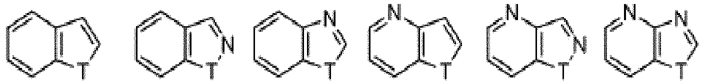 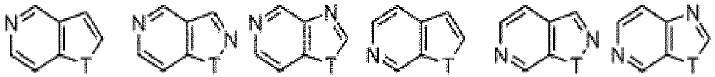 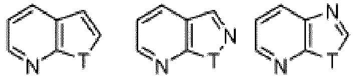 where T is 0, S, NH, N-alkyl, N-aryl, N-(arylalkyl) (e.g., N-benzyl), SiH₂, SiH(alkyl), Si(alkyl)₂, SiH(arylalkyl), Si(arylalkyl)₂, or Si(alkyl)(arylalkyl). Examples of such heteroaryl rings include pyrrolyl, furyl, thienyl, pyridyl, pyrimidyl, pyridazinyl, pyrazinyl, triazolyl, tetrazolyl, pyrazolyl, imidazolyl, isothiazolyl, thiazolyl, thiadiazolyl, isoxazolyl, oxazolyl, oxadiazolyl, indolyl, isoindolyl, benzo furyl, benzothienyl, quinolyl, 2-methylquinolyl, isoquinolyl, quinoxalyl, quinazolyl, benzotriazolyl, benzimidazolyl, benzothiazolyl, benzisothiazolyl, benzisoxazolyl, benzoxadiazolyl, benzoxazolyl, cinnolinyl, 1H-indazolyl, 2H-indazolyl, indolizinyl, isobenzofuyl, naphthyridinyl, phthalazinyl, pteridinyl, purinyl, oxazolopyridinyl, thiazolopyridinyl, imidazopyridinyl, furopyridinyl, thienopyridinyl, pyridopyrimidinyl, pyridopyrazinyl, pyridopyridazinyl, thienothiazolyl, thienoxazolyl, thienoimidazolyl groups, and the like. Further examples of heteroaryl groups include 4,5,6,7- tetrahydroindolyl, tetrahydroquinolinyl, benzothienopyridinyl, benzofuropyridinyl groups, and the like. In some embodiments, heteroaryl groups can be substituted as described herein.

At various places in the present specification, substituents are disclosed in groups or in ranges. It is specifically intended that the description include each and every individual subcombination of the members of such groups and ranges. For example, the term "C₁₋₆ alkyl" is specifically intended to individually disclose C₁, C₂, C₃, C₄, C₅, C₆, C₁-C₆, C₁-C₅, C₁-C₄, C₁-C₃, C₁-C₂, C₂-C₆, C₂-C₅, C₂-C₄, C₂-C₃, C₃-C₆, C₃-C₅, C₃-C₄, C₄-C₆, C₄-C₅, and C₅-C₆ alkyl. By way of other examples, an integer in the range of 0 to 40 is specifically intended to individually disclose 0, 1,2, 3,4, 5, 6, 7, 8, 9, 10, 1 1, 12, 13, 14, 15, 16, 17, 18,19,20,21,22,23,24,25,26,27,28,29,30,31,32,33,34,35,36,37,38,39, and 40, and an integer in the range of 1 to 20 is specifically intended to individually disclose 1,2, 3,4, 5, 6,7, 8, 9, 10, 11, 12, 13, 14, 15, 16, 17, 18, 19, and 20. Additional examples include that the phrase "optionally substituted with 1-5 substituents" is specifically intended to individually disclose a chemical group that can include 0, 1,2, 3,4, 5, 0-5, 0-4, 0-3, 0-2, 0-1, 1-5, 1-4, 1-3,1-2,2-5,2-4,2-3,3-5,3-4, and 4-5 substituents.

Compounds described herein can contain an asymmetric atom (also referred as a chiral center) and some of the compounds can contain two or more asymmetric atoms or centers, which can thus give rise to optical isomers (enantiomers) and geometric isomers (diastereomers). The present teachings include such optical and geometric isomers, including their respective resolved enantiomerically or diastereomerically pure isomers (e.g., (+) or (-) stereoisomer) and their racemic mixtures, as well as other mixtures of the enantiomers and diastereomers. In some embodiments, optical isomers can be obtained in enantiomerically enriched or pure form by standard procedures known to those skilled in the art, which include, for example, chiral separation, diastereomeric salt formation, kinetic resolution, and asymmetric synthesis. The present teachings also encompass cis- and trans-isomers of compounds containing alkenyl moieties (e.g., alkenes, azo, and imines). It also should be understood that the compounds of the present teachings encompass all possible regioisomers
in pure form and mixtures thereof. In some embodiments, the preparation of the present compounds can include separating such isomers using standard separation procedures known to those skilled in the art, for example, by using one or more of column chromatography, thin-layer chromatography, simulated moving-bed chromatography, and high-performance liquid chromatography. However, mixtures of regioisomers can be used similarly to the uses of each individual regioisomer of the present teachings as described herein and/or known by a skilled artisan.

It is specifically contemplated that the depiction of one regioisomer includes any other regioisomers and any regioisomeric mixtures unless specifically stated otherwise.

Throughout the specification, structures may or may not be presented with chemical names. Where any question arises as to nomenclature, the structure prevails.

The present teachings relate to polymeric compounds that can be used as organic semiconductor materials. The present compounds can have good solubility in various common solvents and good stability in air. When incorporated into optical or optoelectronic devices including, but not limited to, photovoltaic or solar cells, light emitting diodes, and light emitting transistors, the present compounds can confer various desirable performance properties. For example, when the present compounds are used in a photoactive layer of a solar cell (e.g., bulk heterojunction devices), the solar cell can exhibit very high power conversion efficiency (e.g., about 3.0% or greater).

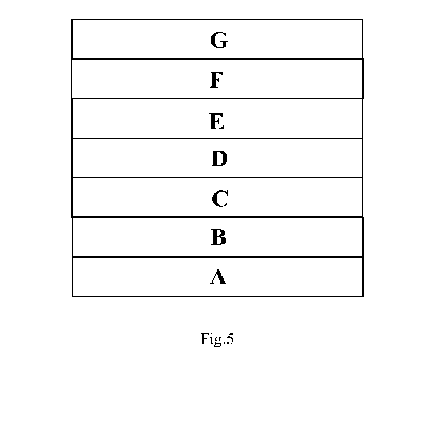

A further object of the present invention is also an organic photovoltaic cell comprising the fullerene derivatives of general formula **(1)** and having an architecture preferably, as shown in Fig. 5. Fig. 5 is a layout of a photovoltaic cell comprising the following components:
a transparent or semitransparent or non-transparent substrate (A);
a bottom electrode (B), which collects the holes from the device;
a hole-selective buffer layer (C), which blocks the electrons and non-dissociated excitations and conducts the holes;
a photoactive layer (D) which functions as generator of free charge carriers under light irradiation and comprises fullerene derivative of the formula **(1)** according to the embodiments of the present invention;
an electron selective buffer layer (E) which blocks the holes and non-dissociated charge carriers and conducts the electrons;
a top electrode (F) which collects the electrons;
a substrate (G) which might be transparent, semitransparent or non-transparent.

In another embodiment of the present invention the components of the photovoltaic cell are arranged in the reversed (or "inverted order") as follows:
a transparent or semitransparent or non-transparent substrate (A);
a bottom electrode (B) which collects the electrons;
an electron selective buffer layer (C) which blocks the holes and non-dissociated charge carriers and conducts the electrons;
a photoactive layer (D) which functions as generator of free charge carriers under light irradiation and comprises fullerene derivative of the formula (1) according to the embodiments of the present invention;
a hole-selective buffer layer (E), which blocks the electrons and non-dissociated excitations and conducts the holes;
a top electrode (F), which collects the holes from the device;
a substrate (G) which might be transparent, semitransparent or non-transparent.

In a preferred embodiment of the present invention the photoactive layer (D) of a solar cell according to Fig. 5 comprises at least one fullerene derivative of the general formula (1) in a pure form or in a form of a composition with other components;

In a very preferred embodiment of the present invention the photoactive layer (D) of a solar cell according to Fig. 5 comprises 1-99% of at least one fullerene derivative of general formula (1) in a combination with 1-99% of an electron donor component. The electron donor component is represented by a fully conjugated or partially conjugated polymer, a low molecular weight compound or inorganic nanoparticle. Preferred electron donor materials include conjugated polymers selected from the group poly(3-hexylthiophene) P₃HT, poly(2,7-(9,9-di(alkyl)-fluorene)-alt-5,5-(4',7'-di-2-thienyl-2',1',3'-benzothiadiazole)) (PFDTBT), poly(2,6-(4,4-bis-(2'-ethylhexyl)-4H-cyclopenta(2,1-b;3,4-6')dithiophene)-alt-4',7'-(2',1',3'-benzothiadiazole) (PCPDTBT), poly(2,6-(4,4-di(n-dodecyl)-4H-cyclopenta(2,1-b;3,4,-6')dithiophene)alt-5,5-(4',7'-di-2-thienyl-2',1',3'-benzothiadiazole)), poly[N-9'-heptadecanyl-2,7-carbazole-alt-5,5-(4',7'-di-2-thienyl-2',1',3'-benzothiadiazole) (PCDTBT), low-molecular weight donor materials, preferably zinc or copper, phthalocyanines, thiophene oligomers, organic dyes and other organic compounds characterized by their ability to form stable cationic species under chemical, photo- or electrochemical oxidation. A range of donor materials can be extended also to inorganic nanoparticles, preferably PbS, PbSe, PdTe, and other types of compounds capable of the electron donation to the fullerene derivative of general formula **(1)** under light irradiation.

In an especially preferred embodiment the fullerene compounds of formula **(1),** preferably compounds of formula **(1a), (1b), (1c), (1d),** more preferably compounds of formula **(1f)** are used in combination with poly(3-hexylthiophene).

In another very preferred embodiment of the present invention the photoactive layer (D) of a solar cell according to Fig. 5 comprises 1-99.999% of a composition of the fullerene derivative of general formula (1) with a donor component in combination with 0.001-99% of a third component which can be another electron donor compound, other electron acceptor compound, processing additive, traces of solvents or other impurities not affecting significantly the performance of the entire photovoltaic device.

In a preferred embodiment of the present invention one substrate, preferably (A) or (G), in a solar cell according to Fig. 5 is semitransparent or transparent. As referred to herein, the transparent material is a material which, at the thickness used in a photovoltaic cell, transmits at least 70% of incident solar light, preferably up to 75%, especially preferred up to 95%. Semitransparent material is a material which, at the thickness used in a photovoltaic cell, transmits from 1 to 70% of the incident solar light. Non-transparent material is a material which, at the thickness used in photovoltaic cell, transmits less than 1% of the incident solar light.

In a very preferred embodiment of the present invention both substrates, preferably (A) and (G) are semitransparent or transparent.

In a preferred embodiment of the present invention the substrates (A) and (G) in a solar cell according to Fig. 5 have a thickness above 0.1 µm (e.g. 0.2 µm or 1 µm) and below 2000 µm, more preferred in the range from 500 µm to 1000 µm.

In a preferred embodiment of the present invention the substrates (A) and (G) in a solar cell according to Fig. 5 are represented by flexible plastic (organic or hybrid) foils with an oxygen transmission rate (OTR) below 10⁻² cc/ m² d and water transmission rate (WTR) below 10⁻² g/ m² d.

In a preferred embodiment of the present invention one of the substrates (A) or (G) in a solar cell according to Fig. 5 is represented by a thin metal foil.

In a very preferred embodiment of the present invention the flexible plastics to be used as the substrates can be composed of at least one compound of the group polyethylene terephthalates, polyimides, polypropylene, polyethylene, cellulosic polymers, polyethers, polyamides, polyketones, or compositions of at least two of these materials with each other, or compositions of at least one of the aforementioned materials with inorganic components, preferably metal oxides, phosphates, nitrides and other functional materials forming compact continuous films.

In one of the possible embodiments of the present invention external, internal or both surfaces of the substrates (A) and (G) can be patterned to improve penetration of the incident light to the active layer of the device, preferably by minimizing reflection losses.

Electrodes (B) and (F) of a solar cell according to Fig. 5 are formed of an organic, inorganic or hybrid material with sufficient electrical conductivity. As referred to herein, sufficient electrical conductivity is reached for a bulk material at the level of at least 500 S/m (e.g. 2000 S/m or 100000 S/m). For the thin films, a surface resistance below 200 Ohm/sq. preferably 15 Ohm/sq., has to be reached to enable sufficient electrical conductivity. Exemplary inorganic materials are represented by metals, preferably silver, aluminium, platinum, gold, nickel, metal alloys, preferably steel or nickel-chrome and conductive metal oxides preferably doped tin oxide, zinc oxide and etc.. Organic conductors are represented by organic meterials, preferably ionic salts formed by tetrathiafulvalenes and tetracyanoquinodimethane, doped conjugated polymers, preferably doped PEDOT or doped polyaniline or doped small molecules preferably doped aromatic amines. Hybrid conducting materials are represented by metal grids coated with organic conducting materials.

A photovoltaic cell according to the present invention, preferably an organic photovoltaic cell according to Fig.5, might optionally include a hole-selective buffer layer (C), which blocks the electrons and non-dissociated excitations and conducts the holes. The hole-selective buffer layer is generally formed from a material which, at the thickness used in the photovoltaic cell, can block efficiently electrons and non-dissociated excitons and transport the positive charge carriers (holes) to the respective electrode. Preferably a hole-selective buffer layer is composed of organic materials, preferably aromatic polyamines, conjugated polymers preferably polyaniline or polythiophenes in a pristine or doped state; inorganic materials, preferably metal oxides very preferred MoO₃, V₂O₅, metal chalcogenides, preferably Ag₂S, CuS and other types of compounds preferably salts, especially preferred CsHSO₄; or hybrid materials represented by blends or layer-by-layer assembles of the aforementioned organic and inorganic materials.

A photovoltaic cell according to the present invention, preferably an organic photovoltaic cell according to Fig.5, might optionally include an electron-selective buffer layer (E), which blocks the holes and non-dissociated excitations and conducts the electrons. The electron-selective buffer layer (E) is generally formed from a material which, at the thickness used in the photovoltaic cell, that can block holes and non-dissociated excitons efficiently and transport the negative charge carriers (electrons) to the respective electrode. An exemplary electron-selective buffer layer is composed of organic materials preferably quinones, halogenated phthalocyanines, nitrogen-based heterocycles, preferably bathocuproine, fullerenes and their derivatives, metal complexes, preferably AlQ₃, and etc, inorganic materials preferably metal chalcogenides, preferably Sb₂S₃, ZnS, ZnSe, CdS, metal oxides, preferably ZnO, TiO₂, MgO, hydroxides preferably NaOH, salts, preferably Na₂CO₃, Cs₂CO₃, LiF, thin metal coatings preferably Al, Ca, Ba, Sr or hybrid materials represented by blends or layer-by-layer assembles of the aforementioned organic and inorganic materials.

In some embodiments of the present invention the hole selective and electron selective buffer layers might contain carbon-based materials such as graphene, graphene oxide, carbon nanotubes, amorphous carbons and tec.

The performance of a photovoltaic device is characterized by the short circuit current, open circuit voltage, fill factor and energy or power conversion efficiency. The term fill factor, as used in the present invention, refers to the ratio of the maximal electrical power produced by the device (Vₘₚ x Iₘₚ) divided by the short circuit current density (I_{SC}) and open circuit voltage (V_{oc}) in light-on current density - voltage characteristics of solar cells. The term short circuit current density (I_{SC}), as used herein, corresponds to the maximal current measured through the load under short-circuit conditions. The term open circuit voltage (V_{oc}), as used herein, is the maximal voltage obtainable at the load under open-circuit conditions. The term power (or energy) conversion efficiency (PCE), as used herein, is the ratio of electrical power output from a device to the light power input (Pᵢₙ) defined as PCE = V_{oc} x I_{sc} x FF under 1 sun (100 mW/cm²) illumination conditions.

The implementation of the fullerene derivatives of general formula (1) improves open circuit voltage (V_{oc}) and overall energy conversion efficiency (PCE) of organic photovoltaic devices.

The present invention is directed to the use of compounds of the formula (1) 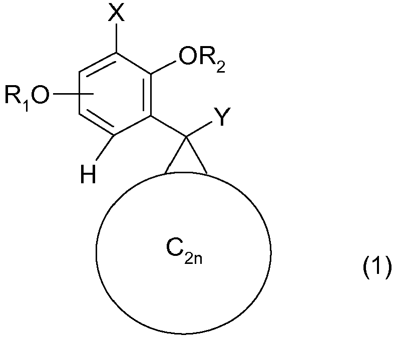 wherein
C₂ₙ is a carbon cage of C₆₀ or C₇₀ fullerene bearing the pendant cyclopropane-type addend,
X represents a substitutent selected from the group of a hydrogen atom, a halogen atom, an optionally substituted C₂-C₂₀ alkyl group, a C₂-C₂₀ fluorinated alkyl group, a C₂-C₂₀ alkyl- ether group, a C₂-C₂₀ alkoxy group, a C₂-C₂₀ fluoroalkoxy group, a C₂-C₂₀ alkylthio group, a C₂-C₂₀ fluoroalkylthio group, a C₅-C₂₀ alkylenearyl group or a C₅-C₂₀ alkyleneheteroaryl group,
Y represents a substitutent selected from the group of a hydrogen atom, an optionally substituted C₁-C₂₀ alkyl chain, a C₁-C₂₀ fluorinated alkyl group, a C₁-C₂₀ alkylether group, a C₁-C₂₀ fluorinated alkylether group, a C₅-C₂₀ alkylenearyl group or a C₅-C₂₀ alkyleneheteroaryl group, an unsubstituted phenyl group, a phenyl group substituted at positions 2 and 4, a phenyl group substituted at positions 2 and 5, a phenyl group substituted at positions 2,3 and 4, a 2-thienyl group substituted at position 5, a (CH₂)₁₋₂₀COOR group, wherein R represents an optionally substituted C₁-C₂₀ alkyl group, a C₁-C₂₀ fluorinated alkyl group, a C₁-C₂₀ alkylether group, or a C₁-C₂₀ fluorinated alkylether group, and
R₁ and R₂ are the same or independet from each other represent an optionally substituted C₃-C₂₀ alkyl group, a C₃-C₂₀ fluorinated alkyl group, a C₂-C₂₀ alkylether group, a C₂-C₂₀ fluorinated alkylether group, a C₅-C₂₀ alkylenearyl group or a alkyleneheteroaryl group or a (CH₂)₁₋₂₀COOR group, wherein R represents an otionally substituted C₁-C₂₀ alkyl group, a C₁-C₂₀ fluorinated alkyl group, a C₂-C₂₀ alkylether group, or a fluorinated C₂-C₂₀ alkylether group in the photoactive layer of a solar cell, preferably of an organic solar cell, more preferred in the photoactive layer (D) according to Fig.5 of an organic photo cell.

The present invention is additionally directed to a process for the enhancement of the power conversion efficiency of solar cells, preferably of organic solar cells by applying compounds of the formula (1) 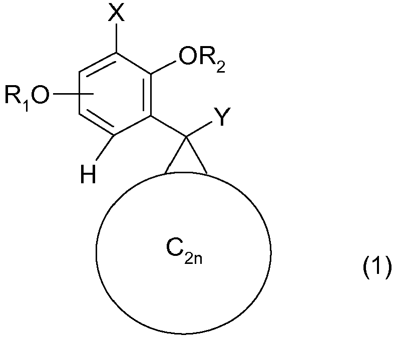 wherein
C₂ₙ is a carbon cage of C₆₀ or C₇₀ fullerene bearing the pendant cyclopropane-type addend,
X represents a substitutent selected from the group of a hydrogen atom, a halogen atom, an optionally substituted C₂-C₂₀ alkyl group, a C₂-C₂₀ fluorinated alkyl group, a C₂-C₂₀ alkyl- ether group, a C₂-C₂₀ alkoxy group, a C₂-C₂₀ fluoroalkoxy group, a C₂-C₂₀ alkylthio group, a C₂-C₂₀ fluoroalkylthio group, a C₅-C₂₀ alkylenearyl group or a C₅-C₂₀ alkyleneheteroaryl group,
Y represents a substitutent selected from the group of a hydrogen atom, an optionally substituted C₁-C₂₀ alkyl chain, a C₁-C₂₀ fluorinated alkyl group, a C₁-C₂₀ alkylether group, a C₁-C₂₀ fluorinated alkylether group, a C₅-C₂₀ alkylenearyl group or a C₅-C₂₀ alkyleneheteroaryl group, an unsubstituted phenyl group, a phenyl group substituted at positions 2 and 4, a phenyl group substituted at positions 2 and 5, a phenyl group substituted at positions 2,3 and 4, a 2-thienyl group substituted at position 5, a (CH₂)₁₋₂₀COOR group, wherein R represents an optionally substituted C₁-C₂₀ alkyl group, a C₁-C₂₀ fluorinated alkyl group, a C₁-C₂₀ alkylether group, or a C₁-C₂₀ fluorinated alkylether group, and
R₁ and R₂ are the same or independet from each other represent an optionally substituted C₃-C₂₀ alkyl group, a C₃-C₂₀ fluorinated alkyl group, a C₂-C₂₀ alkylether group, a C₂-C₂₀ fluorinated alkylether group, a C₅-C₂₀ alkylenearyl group or a alkyleneheteroaryl group or a (CH₂)₁₋₂₀COOR group, wherein R represents an otionally substituted C₁-C₂₀ alkyl group, a C₁-C₂₀ fluorinated alkyl group, a C₂-C₂₀ alkylether group, or a fluorinated C₂-C₂₀ alkylether group in the photoactive layer.

It will be understood that the specification and examples are illustrative but not limitative of the present invention and that other embodiments within the spirit and scope of the invention will suggest themselves to those skilled in the art.

### Examples:

### Example 1 Solar cells comprising compounds of general formula (1) as electron acceptor component and P₃HT as an electron donor polymer

A photovoltaic cell, according to the present invention, as illustrated in Fig. 5, was constructed in the following way. The patterned ITO-coated glass substrates (25 x 25 mm) were sonicated consecutively with acetone, isopropyl alcohol, and deionized water for 10 min. Subsequently, PEDOT:PSS (Clevios HTL Solar) was spin-coated on the ITO-coated glass substrates at ₃000 rpm. The resulting films were dried in air at 180 °C for 15 min. Then the substrates were cooled down to 70 °C (or to the room temperature) and an active layer was deposited on top.

For the active layer deposition, a blend of 9 mg of the fullerene derivative (compound of formula (1) or some reference compound) and 12 mg of P₃HT, both dissolved in 1 ml of chlorobenzene, was spin-coated at the spinning frequency of 900 rpm. The resulting films were annealed at 155°C for 3 min and then the top electrode was deposited in high vacuum (10⁻⁶ mbar) by sequential evaporation of 20 nm of calcium and 100 nm of Ag. The device can be encapsulated using appropriate barrier foils and sealing adhesive materials (to form top substrate (7)).

To illustrate the improved performance of the photovoltaic cells according to the present invention, the current density - voltage (I-V) characteristics were examined for three sets of devices:
- solar cells comprising fullerene derivatives of general formula (1) as electron acceptor components (Set S1) according to the present invention;
- reference solar cells comprising [60]-PCBM as electron acceptor component (Set S2);
- reference solar cells comprising fullerene derivatives with alternative arrangements of alkyloxy substituents in the group appended to the fullerene cage which were also applied as electron acceptor components (Set **S3**);

The obtained solar cell parameters are listed in Table 2. Standard characteristics of photovoltaic cells (e.g. open circuit voltage V_{OC}, short circuit current I_{SC}, fill factor FF, energy (power) conversion efficiency PCE) are given in Table 1 along with two additional parameters: ΔV_{oc} and ΔPCE. The parameter ΔV_{oc} was calculated as V_{oc}(P₃HT/fullerene derivative)-V_{oc}(P₃HT/PCBM) and represents the improvement in the open circuit voltage of the solar cell compared to the reference P₃HT/PCBM device. The parameter ΔPCE was calculated as PCE(P₃HT/fullerene derivative)-PCE(P₃HT/PCBM) and represents the improvement in the overall power (energy) conversion efficiency of the solar cell compared to the reference P₃HT/PCBM device.

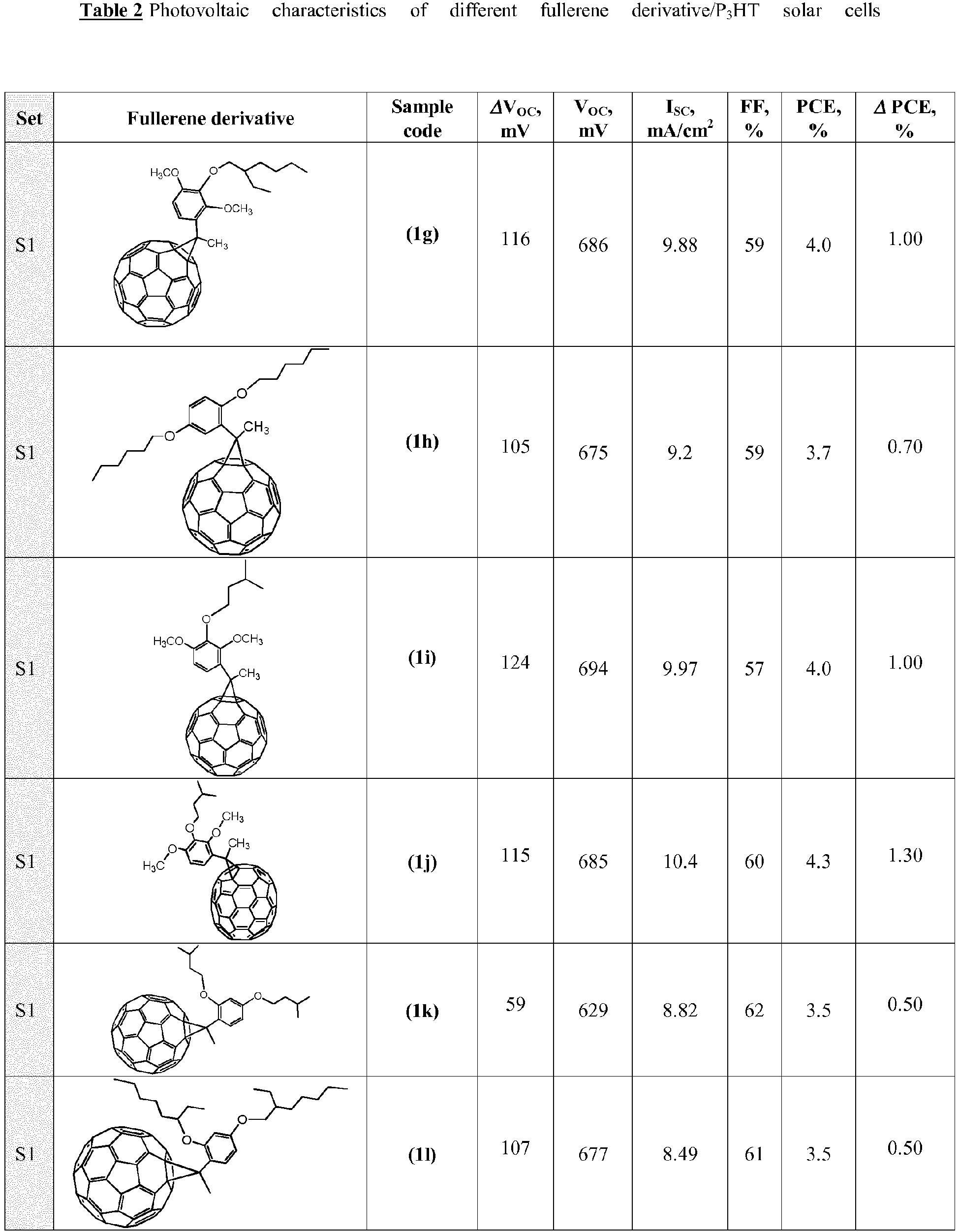

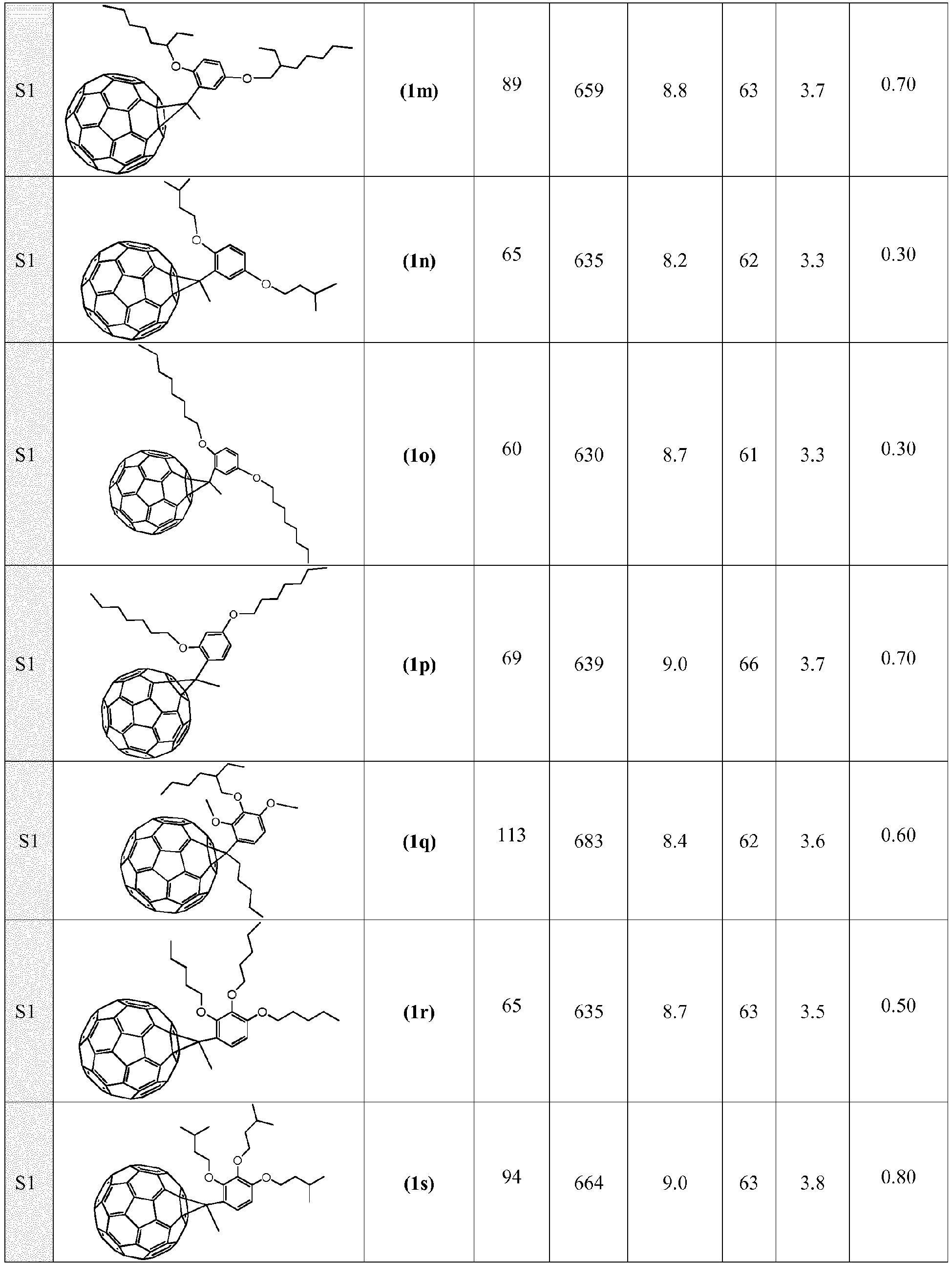

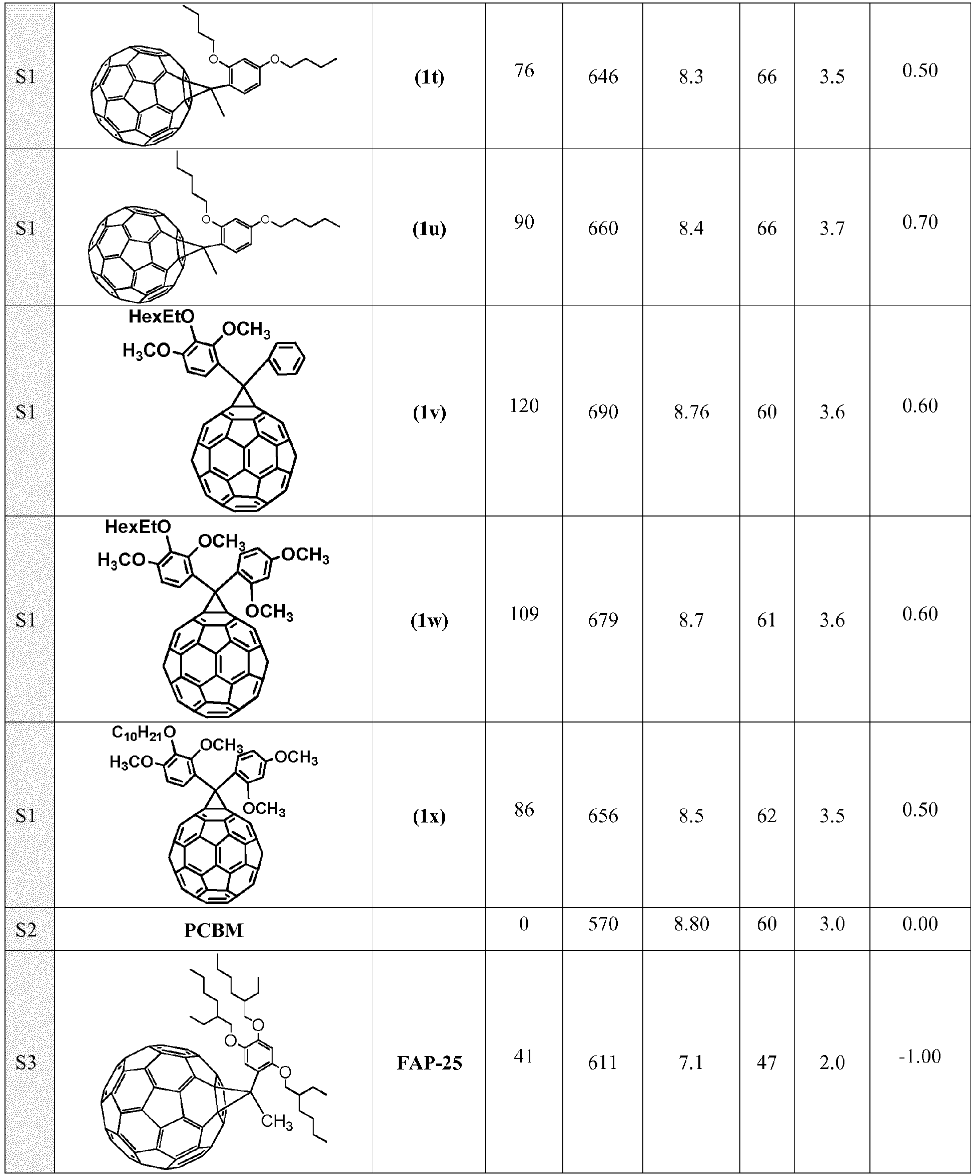

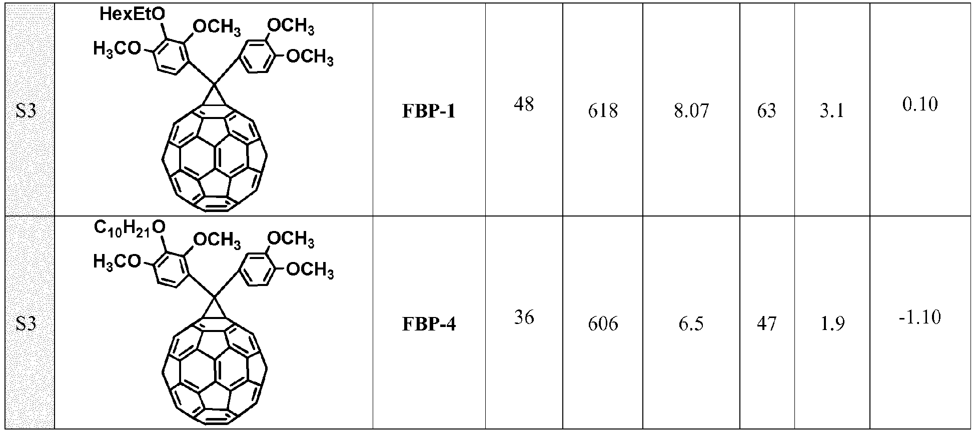

Considering the data presented in Table 2 one can notice that the devices comprising fullerene derivatives of the general formula **(1)** (Set S1) show significantly improved open circuit voltages (ΔV_{OC} from 59 to 124 mV) and improved power conversion efficiencies (ΔPCE from 0.3 to 1.3 %) compared to the reference P3HT/PCBM device (Set S2). Reference fullerene derivatives with alternative arrangements of alkoxy groups in the phenyl rings appended to the fullerene cage (Set S3) show very minor improvement in the open circuit voltage (ΔV_{OC} from 36 to 48 mV) and almost no improvement (or even loss) in the power (energy) conversion efficiency PCE ((ΔPCE from -1.1 to 0.1 %).

The examples demonstrate that relative arrangement of electron donating substituents in the phenyl ring affects significantly photovoltaic performance of the fullerene derivatives used in combination with poly(3-hexylthiophene). This result is rather unexpectable and cannot be envisioned based on the background art.

It should be noted also that the best-performing fullerene derivatives improve the open circuit voltage of the device by 22% (relative vs. PCBM/P3HT reference) and the power (energy) conversion efficiency by 43%.

### Example 2. Solar cells comprising compounds of general formula (1) as electron acceptor component and PCDTBT as an electron donor polymer

A photovoltaic cell, according to the present invention, as illustrated in Fig. 5, can be constructed in the following way. The patterned ITO-coated glass substrates (25 x 25 mm) were sonicated consecutively with acetone, isopropyl alcohol, and deionized water for 10 min. Subsequently, PEDOT:PSS (Clevios HTL Solar) was spin-coated on the ITO-coated glass substrates at 3000 rpm. The resulting films were dried in air at 180 °C for 15 min. Then the substrates were cooled down to 70 °C (or to the room temperature) and an active layer was deposited on top.

Fullerene derivative of general formula **(1)** (16 mg or 24 mg) and 8 mg of PCDTBT were dissolved together in 1 ml of 1,2-dichlorobenzene thus affording 2:1 and 3:1 fullerene derivative/PCDTBT blend solutions. Reference [60]PCBM was blended with PCDTBT in 4:1 w/w ratio according to original publication J. Am. Chem. Soc. 2008, 130, 732-742 (note that 3:1 w/w blends give inferior performance). The resulting blend solutions were spin-coated on the top of the dried PEDOT:PSS films at the spinning frequency of 900-1100 rpm. The resulting films were annealed at 90°C for 1 hour and then the top electrode was deposited in high vacuum (10⁻⁶ mbar) by sequential evaporation of 20 nm of calcium and 100 nm of Ag. The device can be encapsulated using appropriate barrier foils and sealing adhesive materials (to form top substrate (G) in a cell according to Fig. 5).

To illustrate the improved performance of the photovoltaic cells according to the present invention, the current density - voltage (I-V) characteristics were examined for three sets of devices:
- solar cells comprising fullerene derivatives of general formula **(1)** as electron acceptor components (Set C1); according to the present invention;
- reference solar cells comprising [60]PCBM as electron acceptor component (Set **C2)**;
- reference solar cells comprising fullerene derivatives with alternative arrangements of alkyloxy substituents in the group appended to the fullerene cage which were also applied as electron acceptor components (Set **C3**);

The obtained solar cell parameters are listed in Table 3. Standard characteristics of photovoltaic cells (e.g. open circuit voltage V_{oc}, short circuit current I_{sc}, fill factor FF, energy (power) conversion efficiency PCE) are given in Table 3 along with two additional parameters: ΔV_{oc} and ΔPCE. The parameter ΔV_{oc} was calculated as V_{oc}(PCDTBT/fullerene derivative)-V_{oc}(PCDTBT/PCBM) and represents the improvement in the open circuit voltage of the solar cell compared to the reference P3HT/PCBM device. The parameter ΔPCE was calculated as PCE(PCDTBT/fullerene derivative)-PCE(PCDTBT/PCBM) and represents the improvement in the overall power (energy) conversion efficiency of the solar cell compared to the reference PCDTBT /PCBM device.

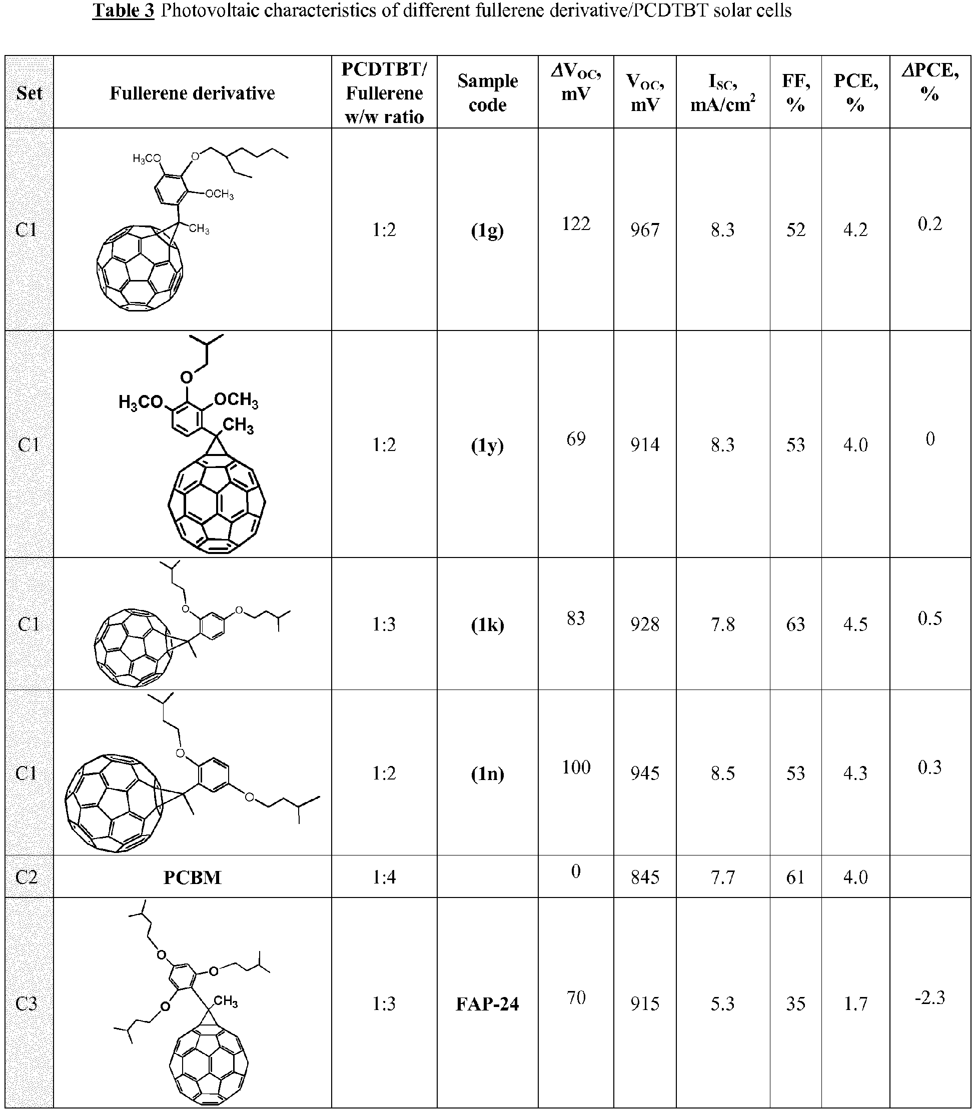

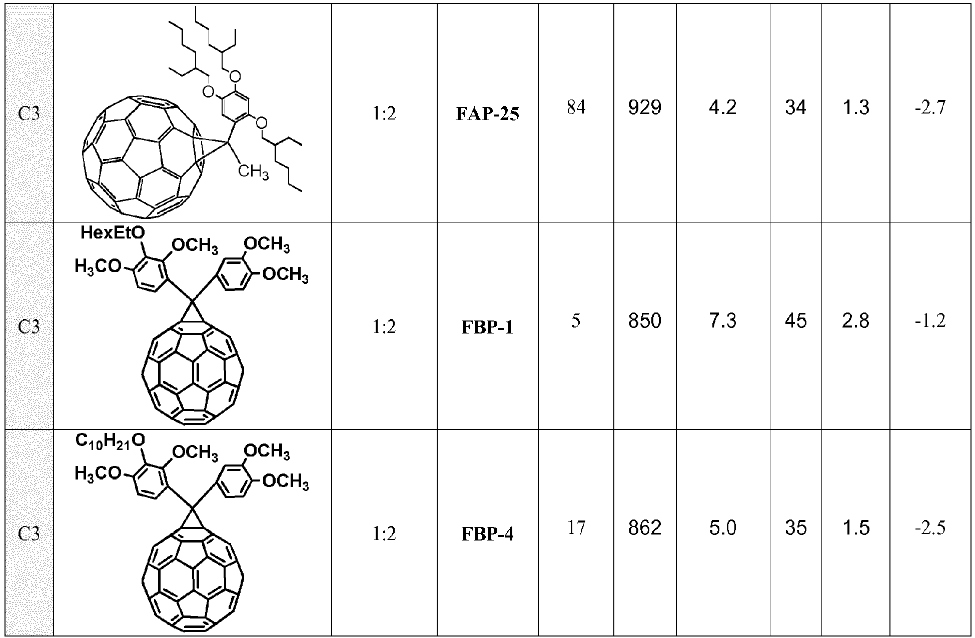

Considering the data presented in Table 3 one can conclude that the devices comprising fullerene derivatives of the general formula (**1**) (Set C1) show notably improved open circuit voltages (ΔV_{oc} from 69 to 122 mV) and power conversion efficiencies (ΔPCE from 0.2 to 0.5 %) compared to the reference P3HT/PCBM device (Set C2). Reference fullerene derivatives with alternative arrangements of alkoxy groups in the phenyl rings appended to the fullerene cage (Set C3) show unsatisfactory performances ((ΔPCE from -1.1 to 0.1 %).

The examples prove again that the arrangement of electron donating substituents in the phenyl ring affects significantly photovoltaic performance of the fullerene derivatives used in combination with a low band gap copolymer such as PCDTBT.

## Claims

1. Compounds of the formula (**1**) 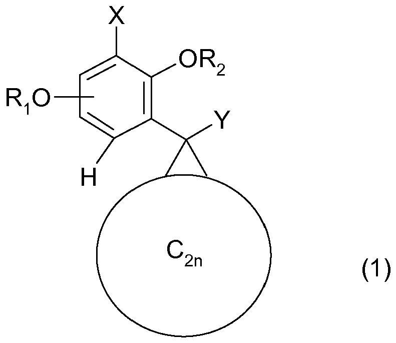 wherein
C₂ₙ is a carbon cage of C₆₀ or C₇₀ fullerene bearing the pendant cyclopropane-type addend,
X represents a substitutent selected from the group of a hydrogen atom, a halogen atom, an optionally substituted C₂-C₂₀ alkyl group, a C₂-C₂₀ fluorinated alkyl group, a C₂-C₂₀ alkylether group, a C₂-C₂₀ alkoxy group, a C₂-C₂₀ fluoroalkoxy group, a C₂-C₂₀ alkylthio group, a C₂-C₂₀ fluoroalkylthio group, a C₅-C₂₀ alkylenearyl group or a C₅-C₂₀ alkyleneheteroaryl group,
Y represents a substitutent selected from the group of a hydrogen atom, an optionally substituted C₁-C₂₀ alkyl chain, a C₁-C₂₀ fluorinated alkyl group, a C₁-C₂₀ alkylether group, a C₁-C₂₀ fluorinated alkylether group, a C₅-C₂₀ alkylenearyl group or a C₅-C₂₀ alkyleneheteroaryl group, an unsubstituted phenyl group, a phenyl group substituted at positions 2 and 4, a phenyl group substituted at positions 2 and 5, a phenyl group substituted at positions 2,3 and 4, a 2-thienyl group substituted at position 5, a (CH₂)₁₋₂₀COOR group, wherein R represents an optionally substituted C₁-C₂₀ alkyl group, a C₁-C₂₀ fluorinated alkyl group, a C₁-C₂₀ alkylether group, or a C₁-C₂₀ fluorinated alkylether group, and
R₁ and R₂ are the same or independent from each other and represent an optionally substituted C₃-C₂₀ alkyl group, a C₃-C₂₀ fluorinated alkyl group, a C₂-C₂₀ alkylether group, a C₂-C₂₀ fluorinated alkylether group, a C₅-C₂₀ alkylenearyl group or a alkyleneheteroaryl group or a (CH₂)₁₋₂₀COOR group, wherein R represents an otionally substituted C₁-C₂₀ alkyl group, a C₁-C₂₀ fluorinated alkyl group, a C₂-C₂₀ alkylether group, or a fluorinated C₂-C₂₀ alkylether group.

2. A compound according to Claim 1 **characterized in that** X≠H, R₁ and R₂ are the same or independent from each other and represent an optionally substituted C₁-C₂₀ alkyl group, a C₁-C₂₀ fluorinated alkyl group, a C₁-C₂₀ fluorinated alkylether group, a C₁-C₂₀ alkylenearyl group or an alkyleneheteroaryl group or a (CH₂)₁₋₂₀COOR group, wherein R represents an optionally substituted C₁-C₂₀ alkyl group, a C₁-C₂₀ fluorinated alkyl group, a C₁-C₂₀ alkylether group, or a C₁-C₂₀ fluorinated alkylether group.

3. A compound according to Claim 1 **characterized in that** when X=H, R₁ and R₂ are the same or independent from each other and represent an optionally substituted C₃-C₂₀ alkyl group, a C₃-C₂₀ fluorinated alkyl group, a C₂-C₂₀ alkylether group, a C₂-C₂₀ fluorinated alkylether group, a C₅-C₂₀ alkylenearyl group or an alkyleneheteroaryl group or a (CH₂)₁₋₂₀COOR group, wherein R represents an otionally substituted C₁-C₂₀ alkyl group, a C₁-C₂₀ fluorinated alkyl group, a C₂-C₂₀ alkylether group, or a fluorinated C₂-C₂₀ alkylether group.

4. A compound according to Claims 1 to 3 **characterized in that** Y represents a C₁-C₂₀ alkyl group or a substitutent selected from the group of an unsubstituted phenyl group, a phenyl group substituted at positions 2 and 4, a phenyl group substituted at positions 2 and 5, a phenyl group substituted at positions 2,3 and 4 or a 2-thienyl group unsubstituted or substituted at positions 4 and/or 5.

5. A compound according to Claim 4 **characterized in that** Y represents a group of formula (2), 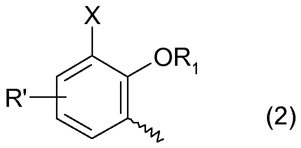 wherein radical R' is a C₂-C₂₀ alkyl group, a C₂-C₂₀ fluorinated alkyl group, a C₂-C₂₀ alkyl ether group, a C₂-C₂₀ alkoxy group, a C₂-C₂₀ fluoroalkoxy group, a C₂-C₂₀ alkylthio group, a C₂-C₂₀ fluoroalkylthio group, or a (CH₂)₁₋₂₀COOR group, wherein R represents an optionally substituted C₁-C₂₀ alkyl group, a C₁-C₂₀ fluorinated alkyl group, a C₂-C₂₀ alkylether group, or a fluorinated C₂-C₂₀ alkylether group.

6. A compound according to Claim 4 **characterized in that** Y represents a C₁-C₈ branched or unbranched alkyl group, preferably a methyl group.

7. A compound according to Claims 1 to 6 **characterized in that** X represents an optionally substituted C₂-C₂₀ alkyl group, a C₂-C₂₀ fluorinated alkyl group, a C₂-C₂₀ alkoxy group, or a C₂-C₂₀ fluoroalkoxy group, preferably an optionally substituted C₂-C₂₀ alkoxy group, more preferred a hydrogen atom.

8. A compound according to Claims 1 to 7 **characterized in that** R₁O and R₂O are attached at positions 2 and 4 of the phenyl ring or R₁O and R₂O are attached at positions 2 and 5 of the phenyl ring and R₁ and R₂ are the same or independent from each other and represent an optionally substituted C₁-C₂₀ alkyl group or a C₁-C₂₀ fluorinated alkyl group, preferably R₁ and R₂ represent the same C₁-C₈ alkyl group.

9. A compound according to Claims 1 to 8 **characterized in that** the fullerene derivatives are those having two alkoxy substituents at positions 2 and 4 of the phenyl ring as shown in the formula **(1a),** or two alkoxy substituents at positions 2 and 5 of the phenyl ring as shown in the formula **(1b),** or three alkoxy substituents at positions 2, 3 and 4 of the phenyl ring as shown in the formula **(1c)** wherein R₃ has the same definition as given above for R₁ and R₂ and C₂ₙ represents either a C₆₀ fullerene or a C₇₀ fullerene system, preferably a C₆₀ fullerene system

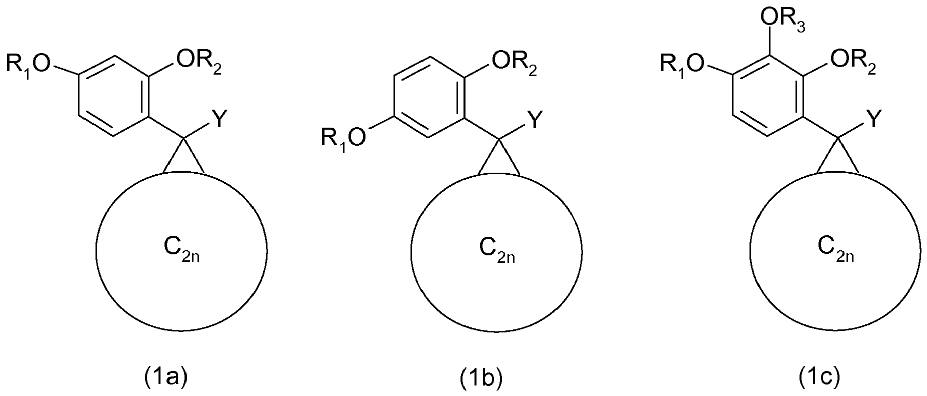

10. A fullerene compound according to Claims 1 to 9 **characterized in that** these having two C₄-C₂₀ alkyloxy substituents in the phenyl ring as shown in formulas **(1a)** and **(1b),** or the ones possessing a single C₅-C₂₀ alkyloxy substituent in combination with two C₁-C₂ alkyloxy substituents as shown in formula **(1d)**

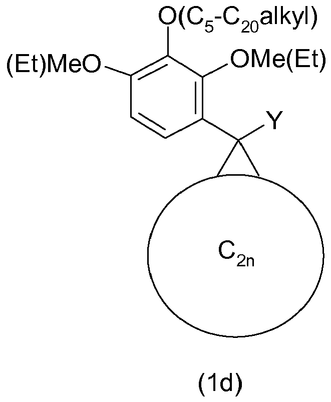

11. A compound according to Claims 1 to 10 **characterized in that** the fullerene is a derivatives
of formula (1f) 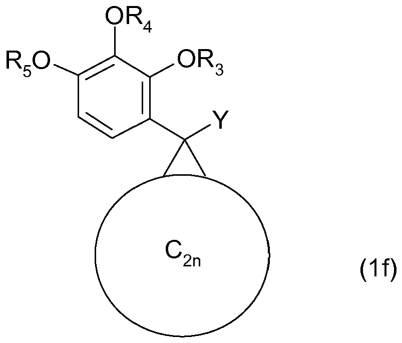 wherein Y represents methyl group, R₃ and R₅ are independent from each other and represent a branched or unbranched C₁-C₈ alkyl group, R₄ represents a branched or unbranched C₃-C₈ alkyl group and C₂ₙ represents either a C₆₀ fullerene or a C₇₀ fullerene system, preferably a C₆₀ fullerene system.

12. A composition comprising 0.1-99.9999% of at least one of the fullerene derivatives according any of the claims 1-11.

13. A composition according to Claim 12, **characterized in that** such composition is the basis of a thin film, preferably a thin film of an photovoltaic cell, more preferred of an organic photovoltaic cell.

14. A photovoltaic cell according to Claim 13 **characterized in that** such cell comprises at least two electrodes, preferably a cell comprising two electrodes, and a functional layer sandwiched in between, where the functional layer contains 1-99% of the fullerene derivative.

15. A photovoltaic cell according to Claim 14 **characterized in that** the photoactive layer comprises at least one fullerene derivative in a combination with 1-99% of an electron donor component.

16. A photovoltaic cell according to Claim 15 **characterized in that** the electron donor component is represented by a fully conjugated or partially conjugated polymer, a low molecular weight compound or inorganic nanoparticle, preferably including conjugated polymers selected from the group poly(3-hexylthiophene) P₃HT, poly(2,7-(9,9-di(alkyl)-fluorene)-alt-5,5-(4',7'-di-2-thienyl-2',1',3'-benzothiadiazole)) (PFDTBT), poly(2,6-(4,4-bis-(2'-ethylhexyl)-4H-cyclopenta(2,1-b;3,4-6')dithiophene)-alt-4',7'-(2',1',3'-benzothiadiazole) (PCPDTBT), poly(2,6-(4,4-di(n-dodecyl)-4H-cyclopenta(2,1-b;3,4,-6')dithiophene)alt-5,5-(4',7'-di-2-thienyl-2',1',3'-benzothiadiazole)), poly[N-9'-heptadecanyl-2,7-carbazole-alt-5,5-(4',7'-di-2-thienyl-2',1',3'-benzothiadiazole) (PCDTBT), more preferred by poly(3-hexylthiophene).

17. The use of a compound of the formula (1) 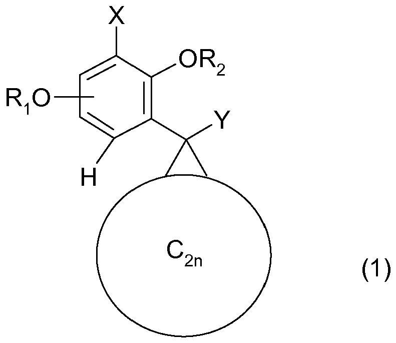 wherein
C₂ₙ is a carbon cage of C₆₀ or C₇₀ fullerene bearing the pendant cyclopropane-type addend,
X represents a substitutent selected from the group of a hydrogen atom, a halogen atom, an optionally substituted C₂-C₂₀ alkyl group, a C₂-C₂₀ fluorinated alkyl group, a C₂-C₂₀ alkylether group, a C₂-C₂₀ alkoxy group, a C₂-C₂₀ fluoroalkoxy group, a C₂-C₂₀ alkylthio group, a C₂-C₂₀ fluoroalkylthio group, a C₅-C₂₀ alkylenearyl group or a C₅-C₂₀ alkyleneheteroaryl group,
Y represents a substitutent selected from the group of a hydrogen atom, an optionally substituted C₁-C₂₀ alkyl chain, a C₁-C₂₀ fluorinated alkyl group, a C₁-C₂₀ alkylether group, a C₁-C₂₀ fluorinated alkylether group, a C₅-C₂₀ alkylenearyl group or a C₅-C₂₀ alkyleneheteroaryl group, an unsubstituted phenyl group, a phenyl group substituted at positions 2 and 4, a phenyl group substituted at positions 2 and 5, a phenyl group substituted at positions 2,3 and 4, a 2-thienyl group substituted at position 5, a (CH₂)₁₋₂₀COOR group, wherein R represents an optionally substituted C₁-C₂₀ alkyl group, a C₁-C₂₀ fluorinated alkyl group, a C₁-C₂₀ alkylether group, or a C₁-C₂₀ fluorinated alkylether group, and
R₁ and R₂ are the same or independet from each other represent an optionally substituted C₃-C₂₀ alkyl group, a C₃-C₂₀ fluorinated alkyl group, a C₂-C₂₀ alkylether group, a C₂-C₂₀ fluorinated alkylether group, a C₅-C₂₀ alkylenearyl group or a alkyleneheteroaryl group or a (CH₂)₁₋₂₀COOR group, wherein R represents an otionally substituted C₁-C₂₀ alkyl group, a C₁-C₂₀ fluorinated alkyl group, a C₂-C₂₀ alkylether group, or a fluorinated C₂-C₂₀ alkylether group in the photoactive layer of a solar cell, preferably of an organic solar cell.

18. A process for the enhancement of the power conversion efficiency of solar cells, preferably of
organic solar cells by applying compounds of the formula (1) 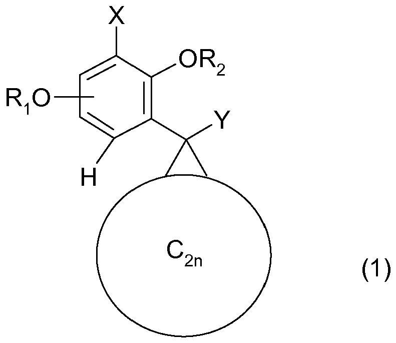 wherein
C₂ₙ is a carbon cage of C₆₀ or C₇₀ fullerene bearing the pendant cyclopropane-type addend,
X represents a substitutent selected from the group of a hydrogen atom, a halogen atom, an optionally substituted C₂-C₂₀ alkyl group, a C₂-C₂₀ fluorinated alkyl group, a C₂-C₂₀ alkylether group, a C₂-C₂₀ alkoxy group, a C₂-C₂₀ fluoroalkoxy group, a C₂-C₂₀ alkylthio group, a C₂-C₂₀ fluoroalkylthio group, a C₅-C₂₀ alkylenearyl group or a C₅-C₂₀ alkyleneheteroaryl group,
Y represents a substitutent selected from the group of a hydrogen atom, an optionally substituted C₁-C₂₀ alkyl chain, a C₁-C₂₀ fluorinated alkyl group, a C₁-C₂₀ alkylether group, a C₁-C₂₀ fluorinated alkylether group, a C₅-C₂₀ alkylenearyl group or a C₅-C₂₀ alkyleneheteroaryl group, an unsubstituted phenyl group, a phenyl group substituted at positions 2 and 4, a phenyl group substituted at positions 2 and 5, a phenyl group substituted at positions 2,3 and 4, a 2-thienyl group substituted at position 5, a (CH₂)₁₋₂₀COOR group, wherein R represents an optionally substituted C₁-C₂₀ alkyl group, a C₁-C₂₀ fluorinated alkyl group, a C₁-C₂₀ alkylether group, or a C₁-C₂₀ fluorinated alkylether group, and
R₁ and R₂ are the same or independent from each other and represent an optionally substituted C₃-C₂₀ alkyl group, a C₃-C₂₀ fluorinated alkyl group, a C₂-C₂₀ alkylether group, a C₂-C₂₀ fluorinated alkylether group, a C₅-C₂₀ alkylenearyl group or a alkyleneheteroaryl group or a (CH₂)₁₋₂₀COOR group, wherein R represents an otionally substituted C₁-C₂₀ alkyl group, a C₁-C₂₀ fluorinated alkyl group, a C₂-C₂₀ alkylether group, or a fluorinated C₂-C₂₀ alkylether group in the photoactive layer.
